(19) Europäisches Patentamt
European Patent Office
Office européen des brevets

(11) EP 4 745 828 A1

(12) **EUROPEAN PATENT APPLICATION**

(43) Date of publication:
**20.05.2026 Bulletin 2026/21**

(21) Application number: **24213734.7**

(22) Date of filing: **18.11.2024**

(51) International Patent Classification (IPC):
**G06F 30/327** (2020.01) **G06F 30/3323** (2020.01)
**G06F 30/337** (2020.01) **G06N 3/126** (2023.01)

(52) Cooperative Patent Classification (CPC):
**G06F 30/327; G06F 30/3323; G06F 30/337;
G06N 3/126**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **University of Limerick
Limerick V94 T9PX (IE)**
• **Technological University
of the Shannon: Midlands Midwest
Limerick, V94 EC5T (IE)**

(72) Inventors:
• **RYAN, Conor
Limerick, V94 T9PX (IE)**
• **SULLIVAN, Joe
Limerick, V94 EC5T (IE)**
• **CONWAY, Richard
Limerick, V94 T9PX (IE)**
• **SARMA, Rajkumar
Limerick, V94 T9PX (IE)**
• **DIAS, Douglas Mota
Limerick, V94 T9PX (IE)**
• **DE BULNES, Darian Reyes Fernández
Limerick, V94 T9PX (IE)**

(74) Representative: **Marks & Clerk LLP
15 Fetter Lane
London EC4A 1BW (GB)**

(54) **CIRCUIT DESIGN GENERATION METHOD AND SYSTEM BY MEANS OF GRAMMAR-BASED OPTIMIZATION**

(57) A computer-implemented method (200) for circuit generation is disclosed, comprising: receiving (202) parameters specifying functionality of a circuit to be designed; optimising (204) one or more circuit designs based on a suitability score that depends at least in part on the suitability of the one or more circuit designs for achieving the specified functionality; wherein the optimising comprises using a grammar based optimisation engine configured to perform a grammar based optimisation in which the one or more circuit designs and any optimisations accord to a selected grammar that describes the structure and/or behaviour of electronic circuits and configured to result in synthesisable circuit components; and the optimising outputs (206) an optimised circuit design.

Fig. 6

EP 4 745 828 A1

## Description

### Field of Invention

The present disclosure relates to generating and modifying circuits, particularly to a computer implemented system and method for use in generating and modifying electrical circuits.

### Background

Generating circuits for digital integrated circuits (ICs) is a skilled, slow, and costly process, with minor errors in design being extremely costly to fix. To make the task tractable, specialised hardware description languages (HDLs) are used to design circuits, which are heavily tested in simulators before being committed to hardware to minimise the costs associated with mistakes at the design stage. For example, candidate circuits described in HDL that pass initial functional testing also need to be "verified" to ensure they can be manufactured, which is another time-consuming step.

Examples of digital circuits that are often designed in this way include embedded devices using ARM, RISC-V or low-powered Intel/AMD processors, and those using low-volume FPGAs. Designing, testing, and fabricating these can be prohibitively expensive, and HDL code is challenging to use and debug. The process of designing such circuits relies largely on engineers fully understanding the problem for which the circuit is being created.

It is an object of the invention to provide a method of designing or generating circuits that is easier and more efficient.

### Summary

According to a first aspect of the present invention, there is provided a computer-implemented method for circuit generation, comprising: receiving parameters specifying functionality of a circuit to be designed; optimising one or more circuit designs based on a suitability score that depends at least in part on the suitability of the one or more circuit designs for achieving the specified functionality; wherein the optimising comprises using a grammar based optimisation engine configured to perform a grammar based optimisation in which the one or more circuit designs and any optimisations accord to a selected grammar that describes the structure and/or behaviour of electronic circuits and is configured to result in synthesisable circuit components; and the optimising outputs an optimised circuit design.

In this way, using a grammar-based approach, circuit designs can be generated that are coherent and described in a complete way that increases the likelihood that generated circuits behave as expected once committed to hardware. This is because rules of the grammar can prevent the generation of designs having components that are connected impermissibly, or designs having components whose connections are incompletely described, which can lead to the unintended generation of latches or other circuit features that affect circuit performance and functionality. This grammar-based optimisation approach has been found to be effective at generating complex circuits based on minimal input from users, enabling less-skilled users to generate effective circuit designs and enabling higher-skilled users to generate effective circuits more efficiently.

The selected grammar is configured to result in synthesisable (i.e., manufacturable) circuit components (and hence circuit designs). This can be achieved by only including manufacturable components in the selected grammar. In other words, circuit components that are useful for performing simulations or modelling but are not manufacturable in practice are excluded from the selected grammar. Generating circuits in this way means that a separate "verification" step is not needed to check the optimal circuit designs can be built, because the composition of the selected grammar already ensures that generated circuits are manufacturable. This allows a time-consuming step in the process of manufacturing circuits to be avoided completely. The term "synthesisable" can also refer to formalising a high-level circuit design into a corresponding design of logic gates or fine-grain hardware (e.g., in-silicon). However, in this context, the "synthesisable circuits" refers to being able to physically create a copy of the generated circuit (i.e., manufacture the circuit or suitably configure a programmable logic device, such as a FPGA, ASIC or other device that is reconfigurable at the hardware level).

Preferably, the selected grammar comprises a plurality of electronic circuit elements that can be combined with one another to form a circuit design, each electronic circuit element comprising either a single circuit component or a combination of circuit components, and a subset of the plurality of electronic circuit elements comprises predefined combinations of circuit components. In this way, useful functionality can be "seeded" in the selected grammar, so that useful circuit modules can be incorporated easily into optimised designs. This helps the method to converge onto a solution more quickly. The predefined combinations of circuit components can have any suitable predefined function. The method can include receiving predefined combinations of circuit components from the user, which allows the user to provide circuit sections or modules they anticipate will be useful for achieving the intended functionality of the circuit to be designed.

Preferably, each of the one or more circuit designs comprises a combination of electronic circuit elements of the plurality of electronic circuit elements, and the optimising includes generating variants of the one or more circuit designs by:

**EP 4 745 828 A1**

combining subsets of electronic circuit elements from two or more previously generated circuit designs, or replacing one or more elements of a previously generated circuit design with one or more different electronic circuit elements, to form a new circuit design. In this way, candidate circuit designs can be generated using previously generated designs. The variants can be generated using any suitable technique, such as grammatical evolution, which is particularly efficient at generating variant designs. Previously generated circuit designs may be selected for generating variants preferentially according to the suitability score of the previously generated circuit designs. For instance, previously generated circuit designs having a better suitability score may be selected preferentially over previously generated circuit designs having a worse suitability score. The previous designs with the best suitability score can be more likely to be selected, or, alternatively, a predetermined number or proportion of the previously generated circuit designs having the best suitability scores can be selected to form the new circuit designs.

Preferably, the selected grammar comprises one or more rules prohibiting the combination of two or more particular electronic circuit elements in a circuit design, or a particular manner of connecting two circuit designs, to avoid or prevent generating non-functioning circuit designs. In this way, it can be ensured that only coherent circuit designs are generated. The rules can include an explicit rule that prohibits two components to be connected (or connected in a particular way). Alternatively, the rules can be implicit by only allowing selected combinations of components included in the selected grammar, whereby non-selected combinations are effectively prohibited.

Preferably, at least one of the subset of the plurality of electronic circuit elements comprises a combination of circuit components that is configured to act as (i.e., be or provide) one or more of: a signal filter, such as a finite impulse response filter, a high-pass filter or a low-pass filter, or an adder, a multiplier, a flip-flop, switch, a multiplexer, a multiplier, a delay element, or a register. The combination of circuit components can be configured to provide any other suitable circuit module or component.

Preferably, the one or more circuit designs comprise components of a hardware description language expressed in a formal grammar. The formal grammar can be an attribute grammar, a Backus-Naur Form (BNF) grammar, or any other suitable formal grammar. BNF grammars, or grammars based on BNF, are useful when exact descriptions are required, and therefore provide a particularly effective grammar for the purposes of circuit generation. The hardware description language can be of any suitable kind, such as Verilog, VHDL, System Verlilog, or the like. The use of a hardware description language expressed in a formal grammar enables optimised circuit designs to accord precisely to the rules of the hardware description language, so that optimised circuits behave as expected during testing and simulation.

Preferably, the optimising comprises simulating iteratively a behaviour of the one or more circuit designs, and, during one or more earlier cycles of simulating iteratively, a first simulation model is used, and, during one or more later cycles of simulating iteratively, a second simulation model is used that different from the first simulation model. In this way, different aspects of the circuit designs can be optimised. The first and second simulation models can be different simulation engines or environments. Alternatively, the first and second simulation models can use the same simulation environment or engine, but with different settings configured to test a different aspect, or the same aspect in more detail, of the circuit designs. In other examples, any other number of simulation models can be used in different cycles.

Preferably, the first simulation model is configured to provide less information (or less accurate information) about a simulated circuit but to execute more quickly compared to the second simulation model and the second simulation model is configured to provide more information, or more accurate information, about a simulated circuit but to execute less quickly compared to the first simulation model. In this way, the method can execute more efficiently because during earlier cycles, circuit designs may not be able to perform the basic functionality set out in the received parameters, such that simulating their behaviour to a high level of accuracy or detail would not be a worthwhile use of computing resources. During later cycles, the optimisation will generally progress the designs until one or several have been found that achieve the basic functionality set out in the received parameters. At this stage, a better-quality simulation will provide information that is more useful and worthwhile obtaining.

Preferably, the first simulation model is configured to perform a functional simulation that simulates a behaviour of a simulated circuit, and the second simulation model is configured to perform a gate-level simulation that simulates a behaviour of the simulated circuit after the circuit has been converted to a corresponding circuit of logic gates. In this way, the circuit designs can be optimised according to different simulation models that simulate different aspects of the circuits behaviour. By optimising using a variety of simulation models, the circuit designs can be tested and optimised as completely as possible, so that the designs behave as expected once committed to hardware. Further, using a variety of simulation models enables automatic performance of all testing stages that a manually designed circuit would be subjected to, further reducing the level of skill required to generate a useful circuit design. In one example, the second simulation model is a gate level timing simulator.

A plurality of different simulation models can be used in different cycles or iterations. Each simulation model can be configured to perform one of: functional testing (e.g., at the HDL level); Post Synthesis Static Timing Analysis (STA); Gate Level Functional Simulation; Post Fitting STA, which may be carried out after each of the circuit designs has been processed by a fitter; and a Gate Level Timing Simulation. The particular simulation models used can be any suitable model known in the art, such as ModelSim and Questa (from Siemens), Incisive Enterprise Simulator (from Cadence), Xilinx Simulator (XSIM) etc. and synthesis tools such as Synopsys Design Compiler NXT, Cadence Genus, Siemens Precision RTL, or the like.

Preferably, the optimising comprises simulating iteratively a behaviour of the one or more circuit designs, and, during one or more cycles of simulating iteratively, the one or more circuits are optimised using less than all of the received parameters. In this way, during the earlier cycles, only a subset of the received parameters are used to perform the optimisation so that the optimisation can begin to converge on a solution more easily because the method is not attempting to optimise all variables simultaneously. During later cycles of simulating iteratively, a larger subset or all of the received parameters may be used to optimise towards a more "complete" solution.

Preferably, the optimising is performed using a grammar-based machine learning tool. In one example, the optimising is performed using a grammar-based genetic programming tool or technique, such as grammatical evolution. Grammatical evolution has been found to be particularly efficient at optimising circuit designs. However, in other embodiments, any other suitable machine learning tool can also be used.

Preferably, the method further comprises manufacturing a circuit according to the optimised one or more circuit designs. The manufactured circuit can be in any suitable form. For example, the manufactured circuit can be in the form of a FPGA or other programmable logic device, an ASIC chip, or any other kind of integrated circuit. The manufacturing can be carried out using any suitable circuit manufacturing process known in the industry, which can include steps such as etching, ion implantation, diffusion, oxide layer growth, patterning, and the like.

Preferably, receiving parameters specifying functionality of a circuit to be designed comprises receiving, from a user, testbench parameters specifying functionality of a circuit to be designed, the testbench parameters comprising sets of one or more input parameters and corresponding sets of one or more output parameters. In this way, the expected outputs corresponding to specific inputs can be designed and the circuit designs can be optimised on this basis. Each set of one or more input parameters and corresponding output parameters can define a particular test case or scenario, such that the sets of testbench parameters can define how the circuit to be designed should behave in various scenarios. This allows the behaviour of the circuit to be described more completely by a user. The testbench parameters can be provided in any suitable form, such as a truth table, a matrix, or any other form known in the art. The input and output parameters can include one or more ideal input signals and one or more corresponding ideal output signals, respectively, for the circuit to be designed.

Preferably, at least one of the one or more output parameters corresponds to a functionality of the circuit to be designed. For example, the one or more of the output parameters may include a particular output signal to be generated in response to a particular input signal or signals.

Preferably, receiving parameters specifying functionality of a circuit to be designed comprises receiving one or more performance parameters specifying a performance of the circuit to be designed. In this way, the circuit designs can be optimised based on performance as well as functionality. The performance parameters can be any suitable variable describing an attribute of the circuit to be designed.

Preferably, the one or more performance parameters specify one or more of: a threshold power consumption, a threshold circuit area, a threshold processing speed, a threshold latency, a threshold throughput, or a threshold component cost. The performance parameters can also define or relate to one or more of: power consumption or dissipation, propagation or other delay, clock frequency (including any of clock latency, jitter and skew), circuit area (i.e., minimum area of the components of the circuit on a chip once manufactured), processing speed, latency (i.e. how long is it permissible to wait between providing inputs in the input parameters to achieve the output parameters), a throughput, total component cost and/or the like.

Preferably, the optimising comprises simulating a behaviour of each of the one or more circuit designs and determining a suitability score for each circuit design using one or more fitness functions that quantify the extent to which sets of output parameters in the received parameters are achieved when each of the one or more circuits are provided with corresponding inputs of the received parameters. In this way, the suitability score can be used to test the circuit designs against the received parameters, so that circuits can be optimised accordingly. The fitness functions can be any suitable kind of function known in the art and could be prepared by persons skilled in the art according to the circumstances of the circuit to be designed. The suitability score can be a collection of outputs of the fitness functions. Alternatively, the suitability score can be the outputs of the fitness functions combined into one or more values using a suitable formula.

Preferably, the optimising comprises: subsequently, determining, based on the suitability scores, that a condition is not met by any of the one or more circuit designs; generating iteratively, sets of variants of circuit designs, and simulating iteratively a behaviour of each circuit design in each set of variants to determine a suitability score for each circuit design using the one or more fitness functions; wherein each set of variants is generated by modifying a corresponding previous set of circuit designs, such that previous circuit designs having higher suitability scores are more likely to be selected to generate a subsequent set of variants; wherein the generating iteratively and simulating iteratively are repeated until a final set of variants is generated and determined, based on corresponding suitability scores, to include one or more circuit designs that meet the condition. The condition can be whether some or all of a minimum functionality and performance defined in received parameters is achieved one or more of the circuit designs. This provides one particular manner of performing the optimisation. However, in other examples, other optimisation techniques could be employed that use the selected grammar to generate coherent circuits.

According to a further aspect of the present invention, there is also provided a computer system comprising: one or more processors; and a memory storing executable instructions that, once executed by the one or more processors, cause the one or more processors to perform steps comprising: receiving parameters specifying functionality of a circuit to be designed; optimising one or more circuit designs based on a suitability score that depends at least in part on the suitability of the one or more circuit designs for achieving the specified functionality; wherein the optimising comprises using a grammar based optimisation engine configured to perform a grammar based optimisation in which the one or more circuit designs and any optimisations accord to a selected grammar that describes the structure and/or behaviour of electronic circuits and is configured to result in synthesisable circuit components; and the optimising outputs an optimised circuit design.

According to a further aspect of the present invention, there is also provided a computer program product which, when executed by one or more processors, causes the one or more processors to perform the method of the first aspect of the invention.

According to a further aspect of the present invention, there is also provided a non-transitory computer readable medium storing instructions which, when executed by a processor, cause the processor to perform steps comprising: receiving parameters specifying functionality of a circuit to be designed; optimising one or more circuit designs based on a suitability score that depends at least in part on the suitability of the one or more circuit designs for achieving the specified functionality; wherein the optimising comprises using a grammar based optimisation engine configured to perform a grammar based optimisation in which the one or more circuit designs and any optimisations accord to a selected grammar that describes the structure and/or behaviour of electronic circuits and is configured to result in synthesisable circuit components; and the optimising outputs an optimised circuit design.

According to a second aspect of the invention, there is provided a computer-implemented method of designing a circuit, comprising: receiving, from a user, testbench parameters specifying intended functionality of a circuit to be designed, the testbench parameters comprising sets of one or more input parameters and corresponding sets of one or more output parameters; generating, using a subset of a grammar of circuit components, the subset of the grammar corresponding to manufacturable circuit components, an initial set of circuit designs in a hardware description language; simulating a behaviour of each circuit design of the initial set of circuit designs and determining a suitability score for each circuit design using one or more fitness functions that quantify the extent to which the sets of output parameters are achieved when each initial circuit is provided with inputs corresponding to the respective sets of input parameters; determining, based on the suitability scores, that a condition is not met by any of the circuit designs in the initial set of circuit designs; generating iteratively, sets of variants of circuit designs, and simulating iteratively a behaviour of each circuit design in each set of variants to determine a suitability score for each circuit design using the one or more fitness functions; wherein each set of variants is generated probabilistically by modifying a corresponding previous set of circuit design, such that previous circuit designs having higher suitability scores are more likely to be selected to generate a subsequent set of variants; wherein the generating iteratively and simulating iteratively are repeated until a final set of variants is generated and determined, based on corresponding suitability scores, to include one or more circuit designs that meet the condition; and outputting the one or more circuit designs to a user.

According to a further aspect of the present invention, there is also provided a computer system comprising: one or more processors; and a memory storing executable instructions that, once executed by the one or more processors, cause the one or more processors to perform steps comprising: receiving, from a user, testbench parameters specifying intended functionality of a circuit to be designed, the testbench parameters comprising sets of one or more input parameters and corresponding sets of one or more output parameters; generating, using a subset of a grammar of circuit components, the subset of the grammar corresponding to manufacturable circuit components, an initial set of circuit designs in a hardware description language; simulating a behaviour of each circuit design of the initial set of circuit designs and determining a suitability score for each circuit design using one or more fitness functions that quantify the extent to which the sets of output parameters are achieved when each initial circuit is provided with inputs corresponding to the respective sets of input parameters; determining, based on the suitability scores, that a condition is not met by any of the circuit designs in the initial set of circuit designs; generating iteratively, sets of variants of circuit designs, and simulating iteratively a behaviour of each circuit design in each set of variants to determine a suitability score for each circuit design using the one or more fitness functions; wherein each set of variants is generated probabilistically by modifying a corresponding previous set of circuit design, such that previous circuit designs having higher suitability scores are more likely to be selected to generate a subsequent set of variants; wherein the generating iteratively and simulating iteratively are repeated until a final set of variants is generated and determined, based on corresponding suitability scores, to include one or more circuit designs that meet the condition; and outputting the one or more circuit designs to a user.

According to a further aspect of the present invention, there is also provided a computer program product which, when executed by one or more processors, causes the one or more processors to perform the method of the second aspect of the invention.

According to the second aspect of the present invention, there is also provided a non-transitory computer readable medium storing instructions which, when executed by a processor, cause the processor to perform steps comprising: receiving, from a user, testbench parameters specifying intended functionality of a circuit to be designed, the testbench parameters comprising sets of one or more input parameters and corresponding sets of one or more output parameters; generating, using a subset of a grammar of circuit components, the subset of the grammar corresponding to manufacturable circuit components, an initial set of circuit designs in a hardware description language; simulating a behaviour of each circuit design of the initial set of circuit designs and determining a suitability score for each circuit design using one or more fitness functions that quantify the extent to which the sets of output parameters are achieved when each initial circuit is provided with inputs corresponding to the respective sets of input parameters; determining, based on the suitability scores, that a condition is not met by any of the circuit designs in the initial set of circuit designs; generating iteratively, sets of variants of circuit designs, and simulating iteratively a behaviour of each circuit design in each set of variants to determine a suitability score for each circuit design using the one or more fitness functions; wherein each set of variants is generated probabilistically by modifying a corresponding previous set of circuit design, such that previous circuit designs having higher suitability scores are more likely to be selected to generate a subsequent set of variants; wherein the generating iteratively and simulating iteratively are repeated until a final set of variants is generated and determined, based on corresponding suitability scores, to include one or more circuit designs that meet the condition; and outputting the one or more circuit designs to a user.

Any of the features of the first aspect of the invention described above can also be implemented or applied to the second aspect of the invention.

The individual features and/or combinations of features defined above in accordance with any aspect of the present invention or below in relation to any specific embodiment of the invention may be utilised, either separately and individually, alone or in combination with any other defined feature, in any other aspect or embodiment of the invention.

Furthermore, the present invention is intended to cover apparatus configured to perform any feature described herein in relation to a method and/or a method of using or producing, using or manufacturing any apparatus feature described herein.

## Description of the Drawings

Various examples of the present disclosure will now be described by way of example, and with reference to the accompanying drawings, of which:

Figure 1 is a schematic diagram of a system according to an embodiment of the invention;

Figure 2A is a flowchart of a circuit generation method according to an embodiment of the invention;

Figure 2B is a flowchart of a circuit generation method according to an embodiment of the invention;

Figure 3A is a schematic diagram of a portion of testbench parameters usable in embodiments of the invention;

Figure 3B is a schematic diagram of a portion of testbench parameters usable in embodiments of the invention;

Figure 4 is a flowchart of a circuit generation method according to an embodiment of the invention;

Figure 5 is a flowchart of a circuit generation method;

Figure 6 is a flowchart of a circuit generation method according to an embodiment of the invention;

Figure 7A shows two graphs of generated circuit designs plotted as a function of their effectiveness as measured by fitness functions after 5 generations (left) and 15 generations (right) of circuit designs;

Figure 7B shows two graphs of generated circuit designs plotted as a function of their effectiveness as measured by fitness functions after 40 generations (left) and 200 generations (right) of circuit designs;

Figure 8 shows a photographic image of an ASIC chip (right) designed and produced according to an embodiment of the invention;

Figure 9 shows a schematic control diagram of a first FPGA and a second FPGA used for prototyping in an embodiment of the invention; and

Figure 10 shows a schematic control diagram of the second FPGA used in an embodiment of the invention.

**Detailed Description of the Drawings**

*1. Systems and methods of the invention.*

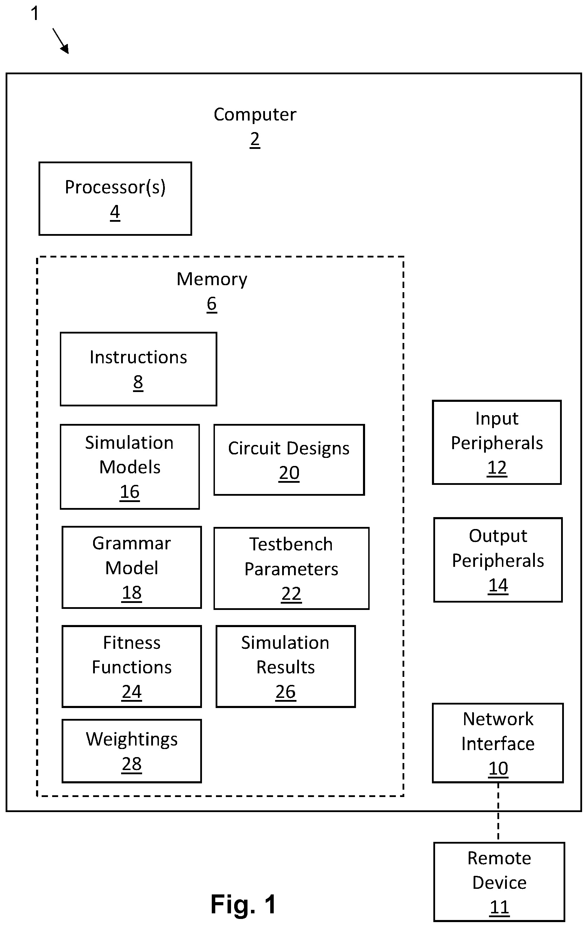

Figure 1 shows a schematic diagram of a system 1 according to an embodiment of the invention.

The system 1 comprises a computer 2 comprising one or more processors 4 and a memory 6 storing executable instructions 8 that can be executed to perform methods of the invention, such as the methods 100, 200 discussed below. A network interface 10 is provided in this example for communicating with other devices over a network, such as the internet. Input peripherals 12 and output peripherals 14 are provided in this example for receiving and providing information from or to a user, respectively.

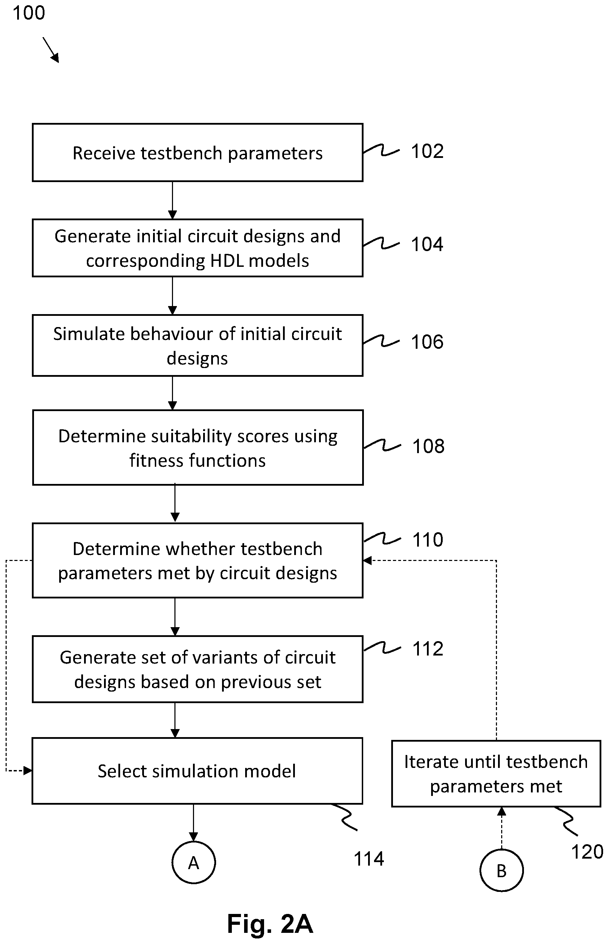

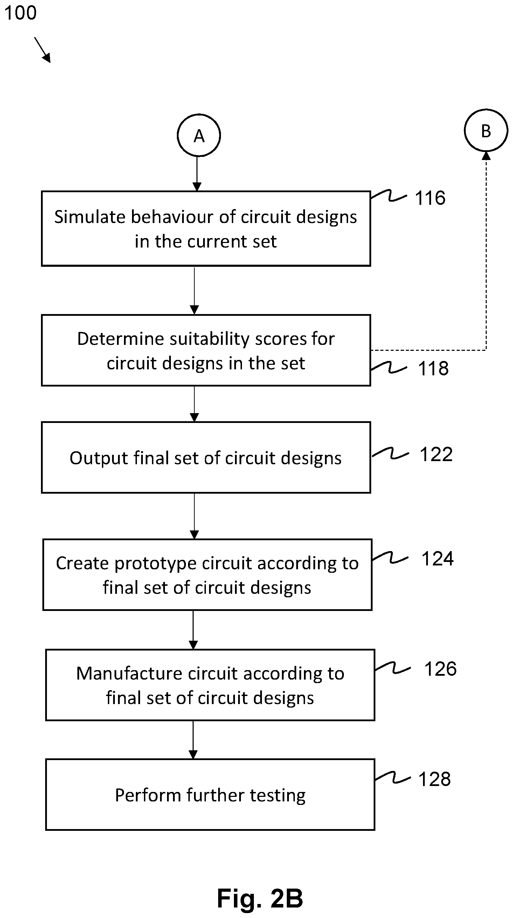

The memory 6 stores various components used to perform methods of the invention, however such components can also be stored remotely in other examples. The memory 6 stores simulation models 16 for simulating various behaviours of circuits. Examples described herein use grammar based optimisation techniques that allow circuit optimisations to be carried out according to a grammar that can be used to guide the optimisation. A particularly beneficial example of a suitable grammar based approach is Grammatical Evolution (GE). In this case, a grammar model 18 is also stored to provide a model and design space for generating candidate circuit designs. The grammar model 16 comprises a set of elements where each element comprises a hardware description language element that defines a single circuit component or a particular combination of circuit components, and rules for combining the elements to form a manufacturable circuit. The memory 6 also comprises circuit designs 20 to be tested by the simulation models 16, and testbench parameters 22 received from a user, e.g. through the input peripherals 12 or through the network interface 10. The memory 6 also stores fitness functions 24, simulation results 26, and weightings 28. The various functions of the components stored in the memory 6 are described in more detail below with reference to Figure 2 and the method 100.

In this example, the system 1 is provided as a single computer 2. However, methods of the invention, such as the method 100 described below, can also be performed by several computers in a distributed fashion across a network. For instance, the computer 2 may send initially generated circuit designs 20 to a remote device 11 for simulation over the network interface 10. The remote device 11 may then send results of the simulation back to the computer 2 as necessary. In another example, the computer 2 may act as a server computer that receives user inputs (such as the testbench parameters 22) over a network and outputs final circuit designs back to the user over the network. It would be appreciated that other steps of the methods described herein can be performed similarly using one or more remote devices.

Figures 2A and 2B show a flowchart of a method 100 according to an embodiment of the invention. The method 100 can be performed by executing the instructions 8 stored in the memory 6 of the computer 2, however any suitable computing device can also perform the method in other examples. Equally, the invention can also be embodied as a computer program product that implements the method 100 when executed by a computer.

The method 100 begins at step 102, at which the user provides the testbench parameters 22 as an input. The testbench parameters 22 comprise sets of input parameters each having a corresponding set of output parameters that define the intended functionality of the circuit the user intends to design. That is, the test bench parameters specify what the circuit should do. Generally, the input parameters include one or more sets of inputs to be provided to the circuit and each corresponding set of output parameters can include the intended output or outputs of the circuit in response to the corresponding set of input parameters.

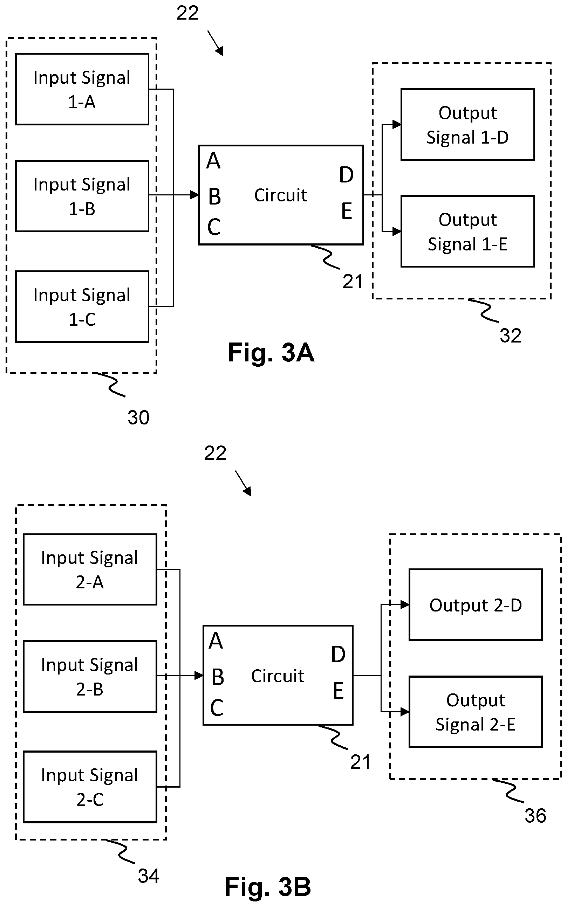

Figure 3A and 3B show schematic representations of exemplary testbench parameters 22. It will be appreciated that the testbench parameters are typically implemented as statements that include, amongst others, statements specifying inputs to be applied and desired outputs. In this example, a circuit 21, i.e., a circuit to be designed (analogous to a device under test (DUT) in a conventional testbench setup), has three inputs (e.g., input signals that could be provided on input pins or connections), inputs A, B and C, and two outputs (e.g., output signals that could be provided on output pins or connections), D and E. A first set of input parameters 30 is provided in the testbench parameters 22, comprising input signals for each input: input signal 1-A, input signal 1-B, and input signal 1-C, each to be provided to a corresponding input of the circuit 21. A corresponding set of output parameters 32 includes desired output signals for each output D, E: output signal 1-D and output signal 1-E. The input signals 1-A to 1-C and the output signals 1-D and 1-E may comprise time varying signals, binary values, or a mixture thereof. Thus, the input parameters 30 and corresponding output parameters 32 provide a scenario that sets out how the circuit 21 should behave in response to certain inputs.

The testbench parameters 22 can include a second scenario defined by different input parameters 34 and corresponding output parameters 36, each with their own sets of input signals (2-A, 2-B, and 2-C) and output signals (2-D and 2-E). This allows the behaviour of the circuit 21 to be defined more completely.

Figures 3A and 3B show two pairs of input and output parameters for the circuit 21; however, it would be appreciated that a much greater number of pairs may be provided in practice. As such, although two scenarios (i.e. two sets of inputs and corresponding outputs) are discussed simply for illustration, the present disclosure is not limited to this and in practice any number of scenarios could be provided, as depending on the application, a circuit may have to perform different operations in relation to different inputs or scenarios. Similarly, it would be appreciated that other circuits to be designed may have different numbers of input and output connections, such as only one input and only one output connection. As such, the present disclosure is not limited to the scenarios shown in Figures 3A and 3B and other testbench parameters are envisaged.

The testbench parameters 22 may also include other information, such as a desired performance of the circuit to be designed. For instance, the testbench parameters 22 may include one or more thresholds or other criteria that need to be met by the circuit, such as but not limited to one or more or any of: power consumption or dissipation, propagation or other delay, clock frequency (including any of clock latency, jitter and skew), circuit area (i.e., minimum area of the components of the circuit on a chip once manufactured), processing speed, latency (i.e., how long is it permissible to wait between providing inputs in the input parameters to achieve the output parameters), a throughput, total component cost and/or the like. Further examples include propagation delay, clock frequency (including clock latency, jitter, and skew), etc., of the desired circuit. Any of the above can be specified in the testbench parameters 22 or, alternatively, can be specified indirectly using the fitness functions 24, described in more detail below. Any other suitable parameters can be provided in the testbench parameters 22 in other examples.

The testbench parameters 22 may be provided in any suitable format as known in the art, for instance as lines of code such as VHDL, Verilog, System Verlilog or other code, a list of statements, a table or matrix of values with specific columns or rows corresponding to inputs, outputs, or performance characteristics, or the like. The testbench parameters 22 may be provided directly to the computer 2 by a user using the input peripherals 12 or alternatively may be provided to the computer 2 over a network.

In step 104, an initial set (also referred to herein as a "generation") of circuit designs 20 are generated using the grammar model 18.

As discussed above, the grammar model 18 comprises a set of elements that correspond to one or more circuit components (such as an adder, multiplier, flip-flop, multiplexer, filter, or more complex components), or combinations of such circuit components. In this example, each element is a code expression that corresponds to one or more specific components of a HDL, for later conversion into HDL or a synthesised gate-level circuit. In other embodiments, the elements of the grammar model 18 may be expressed directly in HDL, or in any other suitable format.

The grammar model 18 also comprises rules defining how the components of each element may be connected with one another. The rules can define permitted combinations of components and permitted ways of connecting components. The components and combinations can include those that are actually synthesisable (i.e. those that can be manufactured and work together) and those that are not. There is a key difference between synthesisable circuits and simulatable circuits. Unsynthesisable components and combinations of components allow circuit designers extra freedom to explore the impact of various design choices. However, simply because a circuit can be simulated doesn't necessarily mean that it can be successfully synthesised. This is because simulation can include non-synthesizable constructs that behave correctly in a software environment but cannot be mapped to actual hardware components, and timing issues or resource constraints might not be fully accounted for in the simulation process. Further, missing conditions or incomplete logic definitions in the HDL code can lead to the unintended generation of latches during the synthesis process, which in turn potentially creates issues such as timing problems, debugging challenges, and/or non-portable designs.

Only a small subset of constructs in a HDL tend to be synthesisable due to an historic focus on providing simulatable circuits, because prior simulation is necessary to design digital circuits in a cost-effective way. This has led to the converse challenge that not all simulated designs can be manufactured. The present invention employs a hybrid automated approach that can employ various simulation models to maximise pre-prototype testing while ensuring only coherent, manufacturable circuit designs are generated.

The grammar model 18 provides a complete syntax for combining circuit components together. In examples of the present disclosure, the grammar that is selected (e.g. selected as a subset of a complete grammar) for use in the grammar model 18 is limited to only elements of grammar (e.g. circuit components or combinations of circuit components) that are synthesisable. For synthesisable elements of the grammar model 18, the generated circuits are necessarily arranged in a manufacturable way that will function as a circuit. For instance, the grammar 18 may prohibit the connection of components in a way that would form short-circuits or latches, would give rise to timing problems, or otherwise lead to undesirable outcomes in generated designs.

In a simplified example, a first element of the grammar model may correspond to component A of the HDL language, a second component may correspond to component B of the HDL language, a third element may correspond to a component C of the HDL language, a fourth element may correspond to components A and B of the HDL language connected in a configuration D, and a fifth element may correspond to components A and B of the HDL language connected in a configuration E that is different from configuration D. Continuing this example, the rules of the grammar model 18 may define that a circuit can comprise two or more of any of the first to fifth elements, except for the first element and the third element, which may not be provided in the same circuit. This means that circuit designs can be generated automatically, using a variety of combinations of elements in the grammar model 18, while ensuring that the resultant circuits have a minimum degree of functionality.

In one example, the grammar model 18 comprises a plurality of elements in the form of a list of HDL indications of circuit components (or combinations thereof) expressed in an exactly defined notation such as Backus-Naur form (BNF), which is a particularly useful notation for when exact descriptions are required. Each circuit and each element can be represented by a "symbol" of BNF, expressed below between angular brackets <>, and each circuit can be represented by one of many possible combination of symbols. In the following simplified example of a portion of the grammar model 18, "|" indicates a possible choice, and "::=" means that the symbol on the left is defined by, or can be replaced by, the expression on the right.

1) <circuit> ::= <first element> <second element> | <first element> <fourth element> | <first element> <fifth element> | ... | <(N-1)th element> <Nth element>

2) <fourth element> ::= <first element> <second element> <connected in manner C>

3) <first element> ::= <HDL component A>

4) <second element> :: = <HDL component B> ...

The first line 1) defines that a candidate circuit design can be composed of a large plurality of possible element combinations for N elements. The second line 2) explains that the fourth element is equivalent to the first and second elements connected in a particular manner C.

The third and fourth lines 3), 4), explain that the first and second elements correspond to a particular component in a HDL language and may be the most granular definition in the grammar model 18. In practice, it would be appreciated that circuit designs may comprise combinations of more than two elements of the grammar model 18 and the grammar model 18 may comprise many more than five elements.

In general, HDLs can define circuit components that are not manufacturable in practice but make simulating performance of circuits described in HDL easier or quicker. The grammar model 18 of the present invention only utilises a subset of components of the HDL language that are known to be manufacturable. Thus, the grammar model 18 can be considered as a subset of a wider grammar of a HDL that contains only manufacturable circuit components. Whether a given component is manufacturable may be indicated by an attribute of each component of the HDL language, for example. The attributes indicating whether each component is manufacturable / synthesisable or not can be set based on previous experience, testing, modelling or simulation, manufacture or other successful use, or any other suitable technique.

Using only a subset of manufacturable components in a syntactically complete grammar ensures that generated circuit designs are both manufacturable and connected in a way that does not generate unexpected circuit features, such as latches. This addresses a problem with known approaches to providing computer-generated circuit designs, in which generated circuits may include components not connected properly, or such that connections between components are incompletely defined, resulting in unintended circuit features, such as latches. The approach of the present invention also avoids a problematic scenario wherein non-manufacturable HDL components in initial designs are used to speed up initial simulations and later it transpires that a seemingly equivalent set of manufacturable HDL components behaves differently in practice.

As mentioned previously, some of the elements of the grammar model 18 comprise a plurality of components connected together, which may be referred to as "composite elements" for brevity. A subset of the composite elements in the grammar model 18 can correspond to circuit modules known to provide a particular function. For example, composite elements may comprise an arrangement of components that provide: a filter (e.g. a high pass filter, a low pass filter, a finite impulse filter, or the like), an adder, multiplier, delay element, a register, or any other suitable circuit module known in the art. A user may be able to input customised circuit modules into the grammar model 18 in order to seed the generated circuit designs with modules that are expected to be useful for fulfilling the desired function. For example, the user may be able to input, as a prior step, lines of code describing a particular form of a basic finite impulse filter as an element of the grammar, which typically comprises at least a few specific components connected in a particular way. The grammar model 18 may have constraints so that the element is connected in a sensible way. This allows the method 100 to converge on a final circuit design more quickly, because useful circuit subsections are built into the grammar model 18.

Returning to step 104, an initial set (or "generation") of circuit designs 20 are generated using the grammar model 18. The set of circuit designs can be referred to as candidate solutions, or individuals, that represent potential solutions to the problem of how to achieve required outputs and/or other goals (e.g. minimising or providing required values of propagation delay, power dissipation, clock frequency, including clock latency, jitter, and skew, and/ or the like) specified in the testbench parameters. In one example, this can be performed by randomly combining elements together, up to a predefined maximum number of elements or components in each circuit, to form a set of candidate circuit designs 20. The number of circuit designs 20 generated in the first generation can be varied, e.g. according to how quickly the user would like the method 100 to be completed, how difficult it is to find an acceptable solution, and so on. In one example, the initial set of circuit designs 20 may comprise 1000, 10,000, or 1,000,000 circuit designs 20, but the present disclosure is not limited to any specific number.

Once the initial set of circuit designs 20 has been generated using the grammar model 18, each circuit design may be converted to suitable HDL code (e.g., using the most granular parts of the grammar model 18 illustrated by steps 3) and 4) above). This allows generated circuit designs to be interpreted and tested by simulation models. Any suitable HDL language known in the art may be used, such as Verilog, SystemVerilog, VHDL or the like.

In step 106, the behaviour of each circuit design in the set of initial circuit designs is simulated. The simulation can be performed using any suitable simulation model known in the art, such as ModelSim and Questa (from Siemens), Incisive Enterprise Simulator (from Cadence), Xilinx Simulator (XSIM) etc. and synthesis tools such as Synopsys Design Compiler NXT, Cadence Genus, or Siemens Precision RTL.

At this stage, the simulation is preferably a high-level functional simulation configured to test the basic functionality of each candidate circuit with respect to the testbench parameters 22 quickly. The high-level functional simulation may provide less information about the circuit designs 20 but execute faster than other simulation models. This is useful because initial circuit designs are likely to perform poorly, such that more detailed simulation models are unlikely to provide useful information early on in the process. The simulation can be performed using a simulation model 16 stored in the memory 6 or, alternatively, could be performed remotely by a remote server after the initial set of circuit designs have been passed to the server.

The simulation results 26 of each simulation may be stored in the memory 6 for later reference.

At step 108, the suitability of each of the generated circuit designs 20 is evaluated using one or more fitness functions 24 to generate suitability scores for each circuit design. The fitness functions 24 generally provide formulas or metrics for scoring how well a generated circuit design achieves the functionality (e.g. the desired outputs, any performance characteristics, physical characteristics, etc.) defined by the testbench parameters 22. This is useful because initially generated designs are highly unlikely to achieve all of the user's intended functionality, meaning that a gradual scale for assessing the designs is needed in order to select the most promising candidate designs.

In this example, the fitness functions 24 receive at least a portion of the testbench parameters 22 as an input, for instance to check how closely simulated output signals resemble intended output signals defined in the testbench parameters 22.

For example, the testbench could implement a truth table of all possible inputs and desired corresponding outputs could be used. It would then compare the output of the circuit under test with the desired output for either all combinations of inputs, or, in some cases, a portion of them. A portion may be desirable where either there are too many inputs to exhaustively test or where the time required to test each is too long because the circuit is complex and requires much time to test.

The fitness functions 24 can be provided by the user at step 108 or as a prior step of the method 100. Alternatively, the memory 6 could store pre-built fitness functions that are generally useful in certain scenarios, and the user can be prompted to select from the pre-built fitness functions or a certain fitness function can be used by default. The simulation results 26 may be used to test retroactively each circuit design against the fitness functions 24. Alternatively, the fitness functions can be applied during the simulation, such that steps 106 and 108 occur approximately at the same time.

The form of the fitness functions 24 may vary depending on the type of circuit to be designed. Two exemplary fitness functions used to evaluate candidate designs for a finite impulse filter, $f_1$ and $f_2$, are:

$$f_1 = NRMSE = \frac{\sqrt{\frac{1}{n}\sum_{i=1}^{n}\left((p_i - t_i)\right)^2}}{max}$$

$$f_2 = 1 - PearsonCorrelation(p, t)$$

where n is the number of training cases, p is a vector of predictions, t is the target vector, and *max* is the maximum possible root mean square error (a measure of how poorly a candidate design filters a signal). A perfect circuit would score zero on both functions, and the lower the score, the better the result. Other examples can use any other suitable formula and may include a single fitness function or more than two fitness functions. Persons skilled in the art would be capable of preparing an appropriate set of fitness functions.

The outputs from each fitness function may be combined together to determine a single suitability score that summarises the overall performance of a candidate design, e.g. using a formula. Alternatively, a suitability score for each circuit can be represented by a collection of the outputs of each fitness function, e.g., as a vector of values, such as $(f_1, f_2)$.

Once the fitness functions 24 have been applied to each of the initial circuit designs, weightings 28 for each of the circuit designs may be set based at least in part on the determined suitability scores. The weightings 28 can be normalised values corresponding to each candidate circuit that determines the probability that a given candidate design will be selected for modification to form subsequent sets or generations of candidate designs. Other factors can also be used to adjust the weightings 28, such as the associated performance, cost, or size of a circuit design. Alternatively, such factors may be assessed by the fitness functions 24, such that a separate adjustment of the weightings 28 is not necessary. Setting weightings 28 may not be required in other embodiments that use suitability scores directly to adjust probabilities of a circuit being selected for subsequent generations of circuit designs.

At step 110, a check is performed to determine whether any of the candidate designs meet a condition, which in this example is whether the functionality set out in the testbench parameters 22 is achieved, or at least achieved to a set or pre-set. This check may be performed by checking the outputs of the fitness functions (or a suitability score derived from those outputs) against a threshold or other criterion, in one example. In other examples, other termination conditions for the iterative process could be used. For example, the iterative process described herein may be performed a set number of times or for a set duration and the candidate design identified during that process that best meets the functionality set out in the testbench parameters 22 is selected as an output. Other termination conditions could be used, such as a rate of change of the suitability score or fitness function between iterations or between a given number of iterations being below a threshold amount, or the like.

Given that the initial set of circuit designs is predominantly selected randomly, the initial set of designs is highly unlikely to contain a working solution. Therefore, for the initial set or sets of candidate designs, this check may be skipped. In this example, the initial check 110 is performed and the initial designs are determined not to provide the functionality set out in the testbench parameters 22, e.g. the functionality set out in the testbench parameters 22 is not achieved or not achieved to the required extent or any other termination condition has not been met.

It should be noted that the method 100 repeats steps 110 to 118 iteratively. Thus, the method 100 later returns to step 110 in subsequent iterations to check whether subsequently generated sets of circuit designs have the desired functionality.

At step 112, a new set of circuit designs is generated, using the grammar model 18, based on the previous set of circuit designs. At this stage, the previous set of designs is the initial set of circuit designs generated in step 104. However, the method 100 will later return to step 112 in subsequent iterations of steps 110 to 118, in which case a new set of circuit designs will be generated based on the circuit designs generated during the most recent previous iteration of step 112. In this way, the designs can be optimised iteratively.

There are various options for generating variations in the designs. For example, the new set of circuit designs can be generated firstly by probabilistically selecting designs in the previous set for modification. The weighting 28 (and thus the suitability score) corresponding to each of the previous circuit designs define the likelihood that they will be selected at this stage, so that the best-performing designs are most likely to be selected for modification. A subset of the previous (in this case, initial) circuit designs are selected and can be modified by, either: randomly replacing one or more elements in the selected design with one or more different elements of the grammar model 18, or copying a whole or part of a different design in the subset and combining this with the selected design. Other ways of modifying the designs can also be implemented, such as by changing the way one or more elements are connected or arranged in the design. Once this has been completed, a new set of candidate designs has been generated. The new set may contain the same number of designs as the initial set, in this case 1000, or alternatively a different number of designs, which may be selected according to the current iteration of step 112.

The generation of new circuit designs in step 112 using the grammar model 18 can be performed using any suitable genetic programming technique. In this example, step 112 is performed using the techniques used in grammatical evolution, which has been found to be particularly efficient.

In other embodiments, circuit designs may not be selected probabilistically. For instance, a subset of the designs corresponding to a predefined number of the best performing designs may be selected.

Once the new set of circuit designs has been generated using the grammar model 18, each of the new circuit designs is converted to a corresponding HDL model (which can be embodied by HDL code) so that the circuit design can be tested by a simulation model. During later iterations, a different simulation model may be selected that simulates behaviour of a "lower-level" version of the circuit designs that does not use HDL, .e.g. the circuit designs expressed as logic gates or in-silicon. In this case, at step 112, the new set of circuit designs can be converted to an alternative appropriate code representation.

If, previously, the check at step 110 reveals that the testbench parameters 22 were achieved by the previous set of designs, then step 112 may be skipped for the current iteration to avoid unnecessarily altering designs found to satisfy the testbench parameters 22.

In step 114, a simulation model 16 is selected based on whether the testbench parameters 22 were determined to be achieved in step 110. In general, the simulation model 16 used and the type of simulation performed (functional, post-synthesis static timing analysis, gate level functional simulation, gate level timing, etc) can differ in different iterations.

Specifically, a first simulation model (e.g., configured to provide functional simulation) may be used for the initial sets of circuit designs 20 until the check at step 110 determines that the testbench parameters 22 have been achieved by the candidate circuits in the current set. Thereafter, a second, different simulation model may be used for testing candidate designs in greater detail, or for testing a different aspect of the candidate designs, such as circuit timing. New generations of designs can be generated in the manner of step 112 described above until the testbench parameters 22 are also achieved according to the simulations performed by the second model. In the same way, third, fourth, or any number of additional simulation models can be used until one or more circuit designs are generated and found to satisfy the testbench parameters 22 when assessed using all of the models. Additionally or alternatively, different fitness functions can be used, with one or more first fitness functions being used for optimisation initially followed by optimisation according to a second set of one or more fitness functions that comprises one or more different fitness functions. For example, the iterative process 110-118 can be used to optimise according to one or more first requirements (which may be specified in the testbench parameters) represented in the first fitness functions, and then after certain termination criteria are met, switching to the second set of fitness functions that represent at least one different criterion.

Therefore, at step 114, the same simulation model as was used to simulate the previous set of circuit designs is selected, unless the check at step 110 reveals that the testbench parameters 22 were achieved by the previous set of designs. It would be appreciated that the selection can be implicit. That is, a simulation model can be "selected" by not changing the model used to test the previous set of circuit designs.

In step 116, the behaviour of the new set of designs is simulated using the simulation model selected in step 114, as described above in step 106.

In step 118, suitability scores are determined for the circuit designs in the current set. Weightings 28 may be assigned to each circuit design based on the corresponding suitability score. The suitability scores generated for each circuit will generally differ from those calculated in step 108 because the new generation of circuit designs are modified with respect to the initial set of circuit designs. The suitability scores for each generation should be at least marginally improved with respect to the previous generation because the most successful subset of candidate designs (as measured using the fitness functions 24) are generally used as the foundation for each next generation of designs. Over many iterations, the sets of generated circuits gradually improve until a set is found to contain at least one circuit functioning as intended. The suitability scores therefore provide a metric for performing optimisation of the designs.

In step 120, the method 100 returns to step 110 to perform a subsequent iterations of steps 110-118.

In this example, new sets of candidate circuit designs (and corresponding HDL models) are iteratively generated and simulated in this manner, using a first functional simulation model, until the check at an iteration of step 110 reveals that the testbench parameters 22 are achieved by at least one circuit design in the set.

At this point, the method 100 skips to step 114 (as indicated by the dashed arrow on the left of Figure 2A), at which a new simulation model is selected. The "new" simulation model can be new in the sense of a completely different simulation model, simulation environment, or simulation engine. Alternatively, the "new" simulation model can be the same model environment or engine as selected previously, but with different settings that allows different aspects of circuit behaviour to be tested (or the same aspects to be tested in more detail). As described previously, the new simulation model can be a simulation model configured to provide more information but which takes longer to execute. Using a less granular model at early iterations of steps 110-118 can significantly improve the performance of the method 100.

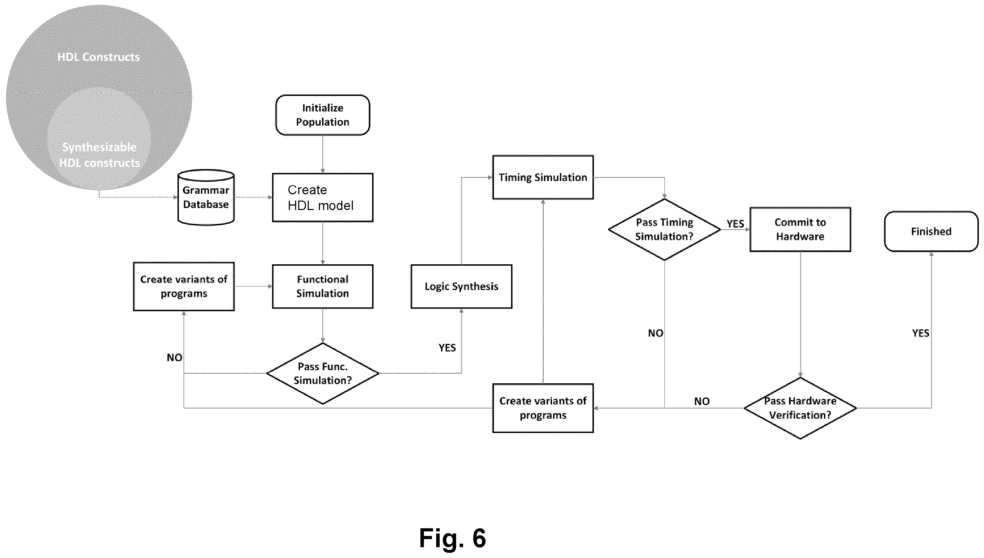

In this example embodiment, four different testing stages are implemented, where different simulation models are used at each of the first three stages of testing and a physical prototype is tested during a fourth stage. Figure 6, discussed further below, shows a flowchart of an alternative method based on three stages (functional simulation, timing simulation, and hardware verification).

Returning to the example method 100, at a first stage of testing, a first functional simulation model is used as described above to test the basic functionality of generated circuit designs. The first functional simulation model is configured to provide quick results but less information or a less accurate simulation, to improve performance of the method 100 during the first stage. The first functional simulation model is used until the check performed at step 110 is passed. For example, the first functional simulation may be based only on optimising against a subset of the output parameters or other requirements specified in the testbench parameters.

Next, during a second stage performed in later iterations of steps 110-118, a second functional simulation model that also tests the functionality of circuit designs is used. The second functional simulation model can provide a more accurate and/or more detailed simulation, which could reveal that one or more circuit designs that seemed previously to satisfy the testbench parameters 22 (or to satisfy the subset of testbench parameters) do not in fact satisfy the testbench parameters 22 (e.g. including any additional testbench parameters) or that the optimisation against the testbench parameters could be improved. The second functional simulation model is used in subsequent iterations of steps 110-118 until the check performed at an iteration of step 110 reveals that one or more circuit designs satisfy the testbench parameters 22.

At a third stage of testing performed in later still iterations, a third simulation model is used. The third simulation model is configured to perform a timing simulation, for instance to assess how quickly the generated circuit designs achieve the outputs specified by the testbench parameters 22 when provided with corresponding inputs. If the tested circuits achieve the intended outputs of the testbench parameters 22 but perform too slowly, for instance, then it can be determined that further iterations are required.

During the third stage of testing, step 112 may involve an additional step of "synthesising" the generated circuits into a form comprised of specific logic gates. This can be performed using any suitable tool and technique as known in the art.

In this example embodiment, three batches of iterations of steps 110-118 are completed for the three different stages of testing described above. In general, the method 100 can use any number of stages of testing based on different simulation models, as known in the art, in which case further batches of iterations of steps 110-118 can be performed. For instance, the method 100 can be performed using only a single simulation model, in which case only a single batch of iterations of steps 110-118 may be performed.

Preferably, however, a plurality of different simulation models are used at different at different iterations of steps 110-118, in order to ensure the generated circuit designs behave as predictably as possible once committed to hardware. In particular, method 100 can include one or more, or all, of the following stages of simulation and testing, which can be performed in the order mentioned: functional testing (at the HDL level), and, after synthesis has been performed: Post Synthesis Static Timing Analysis (STA) and Gate Level Functional Simulation. Subsequently, after circuit designs have been passed to a fitter (sometimes known as a "place and route", where the components and wires from the synthesised designs are placed in silicon): Post Fitting STA, which, similar to the Post Synthesis STA extracts the worst-case delays, and a Gate Level Timing Simulation, which verifies that an otherwise functionally correct simulation won't operate incorrectly due to timing issues such as missing or improperly applied timing constraints or, as is most likely, through routing and buffering issues.

Additionally, between different iterations of steps 110-118 using the same simulation model, less than all of the thresholds or parameters in the testbench parameters 22 may be used to generate the suitability score for each circuit in the method 100. During later iterations also using the same simulation model, a larger subset, or all of, the parameters in the testbench parameters 22 may be assessed by the fitness function. In other words, the number of variables defined in the testbench parameters 22 used to optimise the circuit designs can increase as further optimisation iterations are completed. This can help the method 100 to converge on circuit designs more quickly because the method 100 is not trying to optimise for all variables in the testbench parameters 22 at once. In one example, a specified maximum circuit size and cost (merely as examples) in the testbench parameters 22 may be ignored during earlier iterations and introduced during later iterations. This would help the method 100 converge on a solution that satisfies the remaining parameters (such as circuit power consumption and processing speed) first. Overall, this can improve the performance of the method 100.

Once the first, second and third stages of testing have been completed, i.e. when one or more circuits pass a check at step 110 during the third stage, the method 100 can proceed to step 122.

At step 122 a final set of circuit designs is output to the user. The final set of circuit designs can be a subset of the final set of circuit designs generated in steps 110-118 found to satisfy the testbench parameters performed in all stages of testing.

In this example, the method 100 involves generating about 200 generations ("sets") of circuit designs across the three stages of testing. However, fewer or more generations can be generated in other embodiments.

The final set of circuit designs may generally contain a plurality of circuit designs that meet the criteria specified by the user. The final circuit designs can be analysed and sorted according to different metrics to make it easier for the user to select a particular design. For instance, the designs may be sortable by area size, component cost, speed, or any other suitable metric, to provide a range of solutions to meet the needs of different circumstances.

Advantageously, the syntactically complete grammar model 18 together with the use of a grammar model 18 based only on synthesisable components means that each of the final set of circuit designs is guaranteed to be manufacturable. This avoids a further verification step that is time consuming and would otherwise be necessary to ensure that seemingly final circuit designs can be manufactured in practice.

The final designs can be output to the user in any suitable format known in the art. In the event the method 100 is performed by the computer 2 acting as a server, the final design or set of designs may be forwarded to the user through a network such as the internet.

In some examples, the method 100 can end at step 122. In this example, the method proceeds to optional step 124.

In examples, the final design can be used to create instructions for configuring a hardware level reconfigurable device such as a field programmable gate array, ASIC or other hardware programmable logic device (PLD) in order to implement the final design. In examples, the final design or set of designs can be broken down into process stages associated with different manufacturing steps required to manufacture a circuit according to the final design, such as diffusion, ion implantation, oxide layer growth, patterning, etch, and the like. Manufacturing instructions can be created for each process stage for manufacturing a circuit or part of a circuit according to the final design.

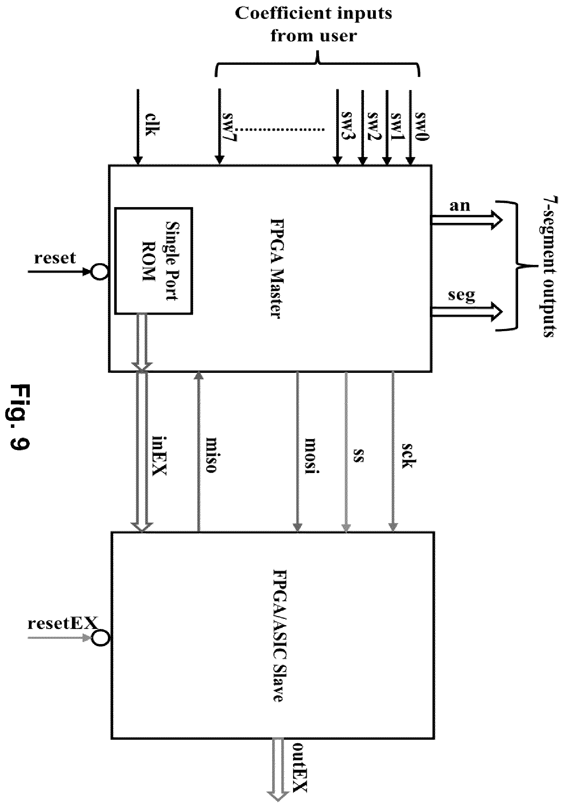

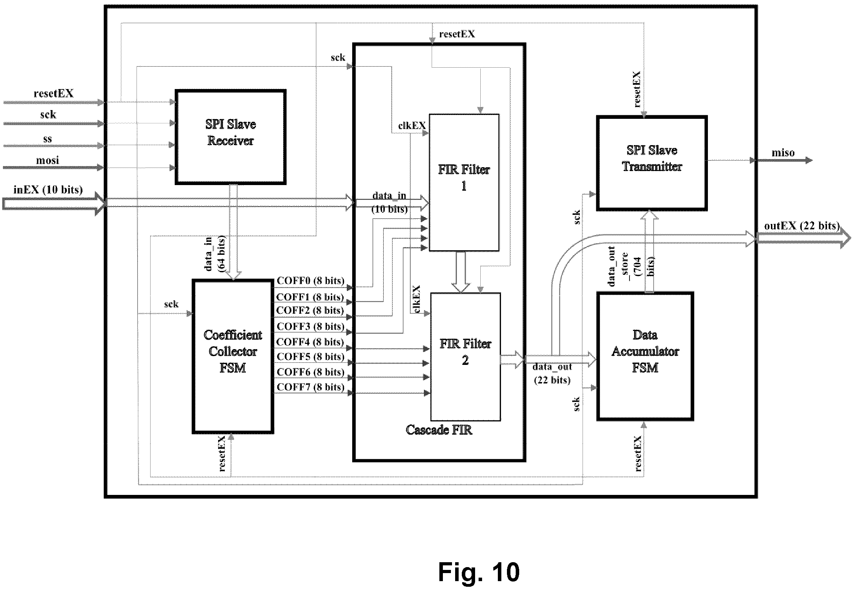

In step 124, one or more prototypes can be made, for example using a field programmable gate array (FPGA) or other programmable logic device, and be subject to further testing as known in the art. One example of how this can be performed is described further below with respect to Figures 9 and 10, in which a first FPGA is used to provide inputs to a second FPGA that is configured according to a generated circuit design. This arrangement can be useful to provide an additional tier of testing and verification of the final circuit design, with the final circuit design being implemented in the second FPGA and the inputs provided by, and the outputs received and optionally analysed for performance by, the first FPGA.

Optionally, equivalence testing is performed on the prototype, as known in the art.

In step 126, which is also optional, one or more of the final set of circuit designs are manufactured. The manufactured circuits are manufactured more efficiently because the circuits can be computer-generated both reliably and to a high degree of complexity in a manner that avoids time-consuming verification steps.

In step 128, which is also optional, the manufactured circuits can be subject to physical testing. For example, the manufactured circuits can be tested to check that they do in fact provide the output functionality intended and at the level of performance intended. Optionally, if the manufactured circuits are determined not to provide the intended functionality or performance, the method 100 can return to the second or third stage of testing, respectively, or any other stage of testing, so that the designs can be refined further.

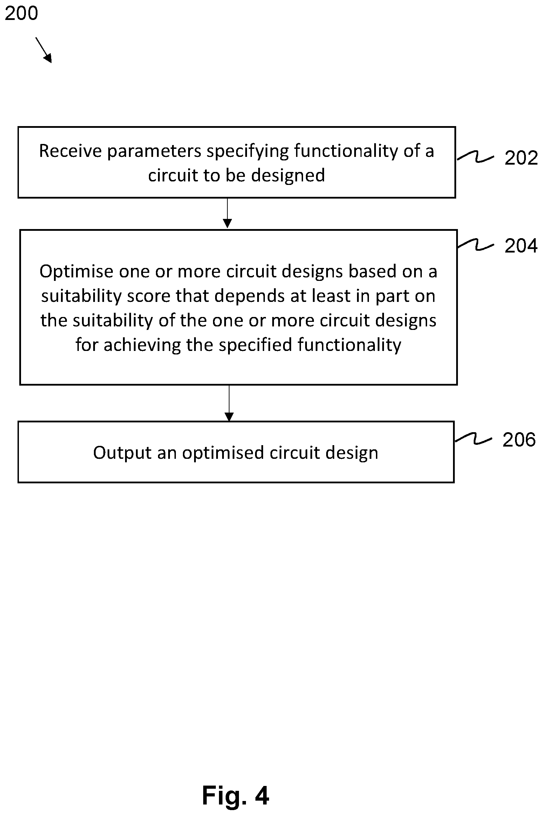

Figure 4 shows a flowchart of a computer-implemented method 200 of circuit generation (i.e., "circuit design") according to an embodiment of the invention. The method 200 can be implemented using the system 1 as described above with reference to Figure 1, or in a distributed fashion. The method 200 can be implemented as a computer program product.

The method 100 described above is a specific example of the more general method 200. Features and steps of the method 100 described above can therefore generally be applied in the method 200.

In step 202, parameters specifying functionality of a circuit to be designed are received. The parameters can correspond to the testbench parameters 22 described above. Alternatively, the parameters can be of any suitable kind and format that specify how a circuit to be designed is to behave. In one example, step 202 can be performed in the manner of step 101 of the method 100.

In step 204, one or more circuit designs are optimised based on a (respective) suitability score that depends at least in part on the suitability of the (respective) one or more circuit designs for achieving the specified functionality. Specifically, the optimising involves using a grammar based optimisation engine configured to perform a grammar based optimisation in which the one or more circuit designs and any optimisations accord to a selected grammar that describes the structure and/or behaviour of electronic circuits and is configured to result in synthesisable circuit components.

The selected grammar can be configured to result in synthesisable circuits by containing circuit elements that can be manufactured in practice only (i.e., by not including circuit elements that can be simulated but cannot be manufactured). Alternatively, or in addition, the selected grammar may contain rules prohibiting the combination of certain circuit components and/or rules specifying how components should be connected, so that stray or incomplete connections are necessarily avoided during the optimisation process. The selected grammar can correspond to the grammar model 18 described above or any other suitable grammar configured to result in synthesisable circuits.

The grammar based optimisation can be performed in any suitable manner, for instance using genetic programming (such as grammatical evolution) to generate sets of candidate circuit designs that are modified versions of a preceding generated set. One or more simulators can be used to simulate behaviours of the one or more circuits and generate suitability scores based on the simulated behaviour. The suitability scores may be calculated using the received parameters and one or more functions (such as the fitness functions 24 discussed above).

In one example, the optimisation can be performed using the iterative approach of steps 104-118 described above. However, any other optimisation technique known in the art that can be employed.

In any case, the optimisation is performed using a grammar in order to prevent the generation of circuits that are not manufacturable in practice, or are generated with an incomplete definition that results in an unexpected change in behaviour of the circuit once it is manufactured. This significantly speeds up the time required to manufacture a circuit because hardware verification (verifying a circuit can be manufactured) happens inherently, rather than as a separate (usually time consuming) step.

In step 208, an optimised circuit design is output from the optimisation of the previous step. The optimised circuit design can be provided as one of several optimised designs determined to exhibit or achieve the functionality specified in the received parameters. The circuit design can be provided in any suitable format.

*2. Further Background and Specific Example*

The following section describes further background to the invention and a specific example of the method performed to generate and manufacture a design for an application specific integrated circuit (ASIC).

Problem of the invention

Many industries rely on digital circuits in some way. These can vary from embedded devices using ARM, RISC-V or low-powered Intel/AMD processors to those using low-volume FPGAs. Designing, testing, and fabricating these can be prohibitively expensive, and HDL code is challenging to use and debug. More recently, high level synthesis (HLS) tools have been used, enabling engineers to write code in higher-level languages such as C, C++ or MATLAB, which are subsequently translated into an HDL. Regardless of whether HDL or HLS to HDL conversion is used, the circuit design relies almost wholly on engineers fully understanding the problem for which the circuit is being created. To summarize, there is currently no fully automated tool for generating digital circuits, which are crucial to many industries.

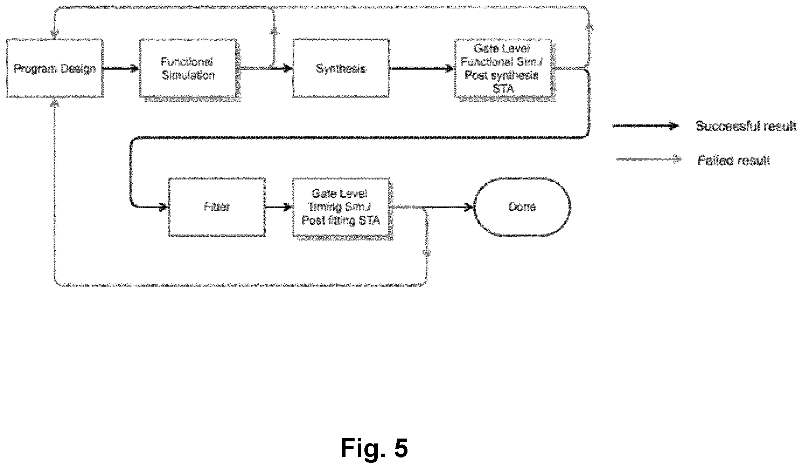

With a few exceptions, in general, modern circuits are not created from logic gates, rather from HDLs, with the relationship between gate- and HDL-level being analogous to that between Assembler and high-level programming language. HDLs have been around since the 1960s, but really began to gain popularity in the eighties as VLSI (very large-scale integration) ICs became increasingly available. The complexity of their design demanded sophisticated languages to describe circuits, and the CAD flow in Figure 5 became the standard approach. Figure 5 shows a typical computer aided design (CAD) flow for circuit design. The "functional simulation", "gate level functional simulation" / post synthesis static timing analysis (STA) are simulations and timing while "synthesis" and "fitter" are steps performed by standard tools in the industry. Failure at any of the simulations or analyses results in redesign.

With reference to Figure 5, first, a circuit model is designed using an HDL and subjected to a functional test to determine if the circuit behaves as expected. Due to the prohibitive costs of mistakes in circuit design, particularly for ASICs, simulator technology in the IC world is very sophisticated; in fact, the common approach is to use an HDL for both the circuit being simulated and to write test routines for the simulator. Testing is such an important part of this world that the majority of time spent by design teams is in testing and verification. In some cases, the designer will perform formal verification while constructing the program (i.e., the HDL model of the circuit); this takes the form of formal assertions that help describe what the circuit should do, e.g. if Property A holds then Property B must also hold. While formal verification doesn't always provide complete testing coverage it can, when it can be used, provide a good first test and sits in front of the functional test.

Failure at this point requires redesign, and this continues until all tests have been satisfied, at which point the design is compiled into a netlist, which is essentially a set of logic primitives such as AND, OR, NOT, flip-flops, etc. This step, which is analogous to compilation in the software world, is known as synthesis. Two more tests are then applied to the netlist. The first, Post Synthesis Static Timing Analysis (STA), extracts the worst-case delays based on the circuit topology; if these delays are unacceptable, then redesign is required. The second, the Gate Level Functional Simulation, performs what is essentially another functional simulation, but which yields different information from the first. They differ because of how much lower the level is; that is, it is possible that behaviour described in the initial design is too complex to be realised in gates.

Once the design team is satisfied that the circuit is functionally correct, it is then passed to a Fitter, which performs what is sometimes known as a "place and route", where the components and wires from the netlist are placed in silicon. Two more timing tests are performed on this circuit, the Post Fitting STA which, similar to the Post Synthesis STA extracts the worst-case delays, and a Gate Level Timing Simulation, which verifies that an otherwise functionally correct simulation won't operate incorrectly due to timing issues such as missing or improperly applied timing constraints or, as is most likely, through routing and buffering issues.

Any problems highlighted at this step may be corrected either by using the Fitter to create a different layout, or, possibly, by modifying the design and going back to the Synthesis step.

After successfully passing all simulated tests, a FPGA is programmed and configured as a prototype, translating the designed circuit into Logic Equivalents (LEs) and interconnected wires within the physical silicon of the FPGA. Subsequently, final equivalence testing is conducted to verify that the hardware operates correctly. Once the designer confirms satisfaction with the FPGA's output, the netlist along with the design constraint files are forwarded to the foundry and packaging vendor for the fabrication of the ASIC.

A fully automated system for digital circuit design is proposed herein, which can be referred to as Automatic Design of Digital Circuits (ADDC). The ADDC techniques proposed can include a combination of Machine Learning (ML) and standard silicon simulation tools, providing a fully automated general circuit synthesis tool. Users needs only to provide test benches that specify what the circuit should do, and ADDC automatically generates a physical circuit that performs the task.

Examples of ADDC disclosed herein use grammar based techniques that can be used to guide the circuit optimisation to correct solutions, particularly Grammatical Evolution (GE), a powerful automatic programming technique. The inventors have used its capability to utilize ML and create a silicon chip design, which has been fabricated. The chip was prototyped on an FPGA board and later fabricated using 65 nm technology. The functional testing and verification of the fabricated chip is described briefly below.

As discussed, examples of ADDC disclosed herein operate on grammar based techniques, particularly Grammatical Evolution (GE), a form of ML, and can automatically generate software from high-level descriptions, often in the form of test cases resembling regression tests. GE generates candidate solutions, referred to as individuals, which represent potential solutions to an outlined problem. These individuals undergo testing and scoring via a 'fitness function' that assesses their performance based on how effectively they address the test cases. Through iterative refinement, individuals are continuously improved until one emerges that effectively solves all test cases while meeting additional constraints such as size and speed.

Examples of the present disclosure use a version of GE to automatically generate, test and implement HDL models in hardware, using HDLs, such as Verilog, SystemVerilog and VHDL, the three most popular HDLs. Examples of target hardware include both FPGAs and ASICs as well as other programmable logic devices (PLDs). The ADDC proposed in examples plugs into, and re-purposes, parts of the traditional CAD flow, using existing, industry standard circuit simulators such as ModelSim and Questa (from Siemens), Incisive Enterprise Simulator (from Cadence), Xilinx Simulator (XSIM) etc. and synthesis tools such as Synopsys Design Compiler NXT, Cadence Genus, Siemens Precision RTL etc.

Figure 6 shows a flowchart of a method according to an embodiment of the invention, i.e. according to ADDC. The following steps of Figure 6 are steps that can be completed using existing, industry-standard tools and methods: "functional simulation", "formal verification (possibly)", "synthesis", "timing simulation", and "commit to hardware". The following components or steps of Figure 6 represent aspects specific to the embodiment of the invention, i.e., part of ADDC: "initialise population", "create HDL model", "grammar database", "create variants of programs". The method of Figure 6 corresponds to a specific implementation of the method 100 or 200 as described above.

The fitness function comprises a testbench, the standard CAD method for determining whether a circuit is functionally correct and can also incorporate other constraints. These constraints can include propagation delay, power dissipation, clock frequency (including clock latency, jitter, and skew), etc., of the desired circuit. The output can be a Pareto set (selection) of circuits, each of which satisfies the constraints while offering different trade-offs, e.g. power versus speed, etc.

A significant inherent feature of the present approach is that verification explicitly occurs within the design generation, eliminating a separate verification step after design. This offers design teams enhanced productivity, as typical verification time costs are more than 60% of the design team's total time. All testing can be done with the same industry-standard tools that are common in the art, providing backwards compatibility.

Specific Example - ASIC

To show the effectiveness of the techniques disclosed herein, ADDC as described herein has been used to create a silicon chip, known as an Application Specific Integrated Circuit (ASIC). The chip is relatively simple (and described below), but has been designed end-to-end in a computer-generated manner using embodiments of the invention. The ASIC described below has been successfully tested.

The example chip is a Finite Impulse Response (FIR) filter. It was evolved from scratch using the open-source Icarus simulation tool before being synthesised using the Cadence Genus tool. FIR filters are commonly used tools in digital signal processing as they can remove noise from signals; they are often used in audio processing and telecommunications and have recently seen an uptick in use in ML, specifically for feature extraction and data preprocessing.

The fitness function in this example was the ability of the circuit to successfully filter a noisy signal, which was measured in two ways, $f_1$ and $f_2$:

$$f_1 = NRMSE = \frac{\sqrt{\frac{1}{n}\sum_{i=1}^{n}\left((p_i - t_i)\right)^2}}{max}$$

$$f_2 = 1 - PearsonCorrelation(p, t)$$

where n is the number of training cases, p is the vector of predictions, t is the target vector, and max is the maximum possible root mean square error (a measure of how poorly an individual filtered the signal). A perfect circuit would score zero on both functions. In this example, generating the optimised circuit took around 3 hours.

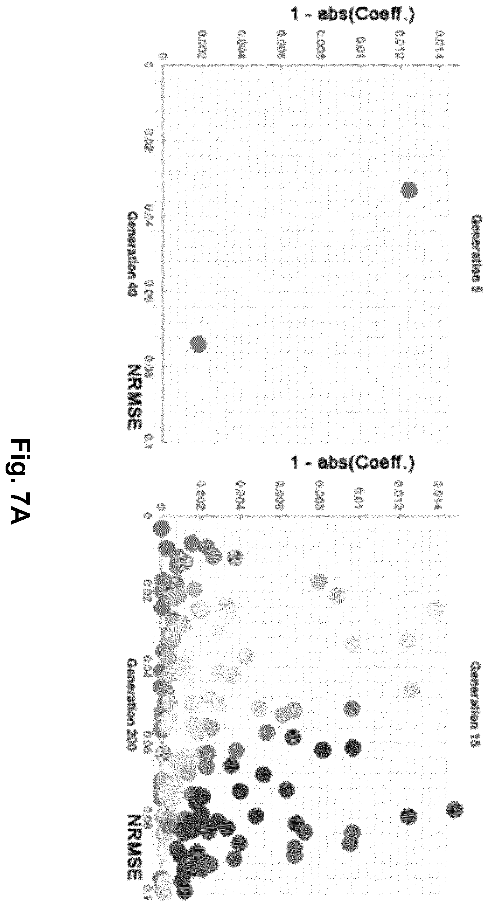

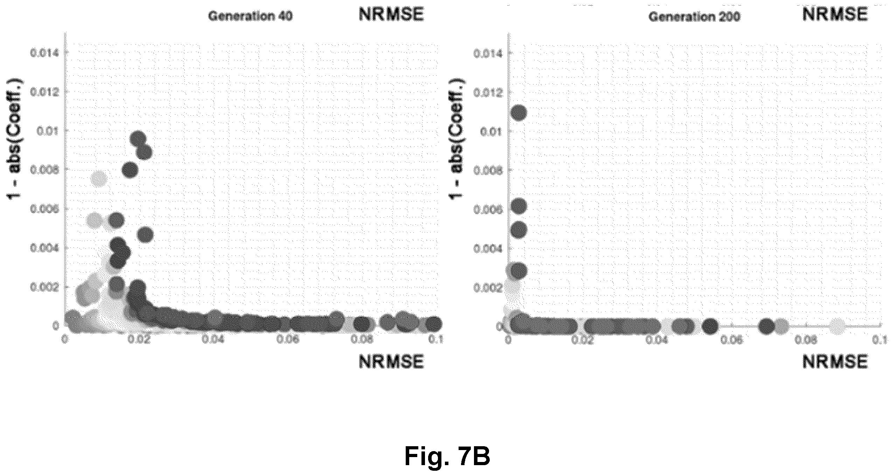

Figures 7A and 7B show graphs illustrating a collection of generated FIR filter circuits for different numbers of generations (i.e., sets of circuit designs). Each axis represents an output of one of the fitness functions $f_1$, $f_2$, such that dots closer to the origin represent better solutions (or at least solutions with satisfy the fitness functions to a greater extent). Dots of the same colour or pattern represent solutions on the same Pareto front. Each generation represents a single iteration of refinement.

As shown by the left graph in Figure 7A, after 5 generations, two circuit designs are found. However, as shown by the right graph, after 15 generations of circuit designs have been generated, simulated and tested, many more candidate solutions were found. The left and right graphs of Figure 7B show the number of solutions found after 40 and 200 sets of circuit designs, respectively, had been generated, simulated and tested.

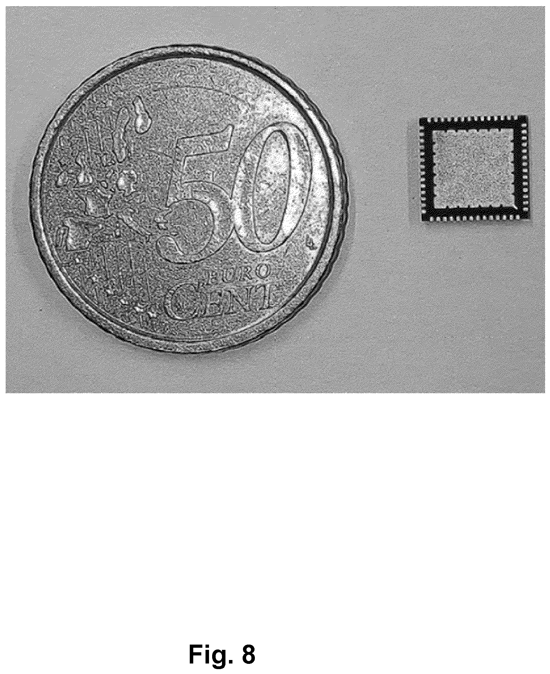

The fabricated ASIC chip is shown in Figure 8 (right) next to a 50 cent (Euro) coin for comparison (left).

The evolved (i.e., generated) FIR filter was synthesised on Cadence Genus with 65 nm technology. The synthesised report in Table 1, which shows the chip area, power, and delay comparison with an ideal process but with different voltage and temperature corners, showing the trade-off between power and delay. The maximum and minimum power consumptions are recorded as 21.3 mW at BC and 13.9 mW at WCL, respectively. The maximum and minimum delay recorded are 8303 pS at WCL and 1542 pS at LT, respectively.

Table 1: Area, power and delay analysis of the evolved FIR ASIC at different corners of TSMC 65nm Technology. BC: Best Case, LT: Low Temperature Best Case, TC: Typical Case, WC: Worst Case, WCL: Worst Case Low Temperature (-40C).

|  | BC | LT | TC | WC | WCL |
| --- | --- | --- | --- | --- | --- |
| Temperature (Celsius) | 0° | -40° | 25° | 125° | -40° |
| Core Voltage (Volts) | 1.32 | 1.32 | 1.2 | 1.08 | 1.08 |
| IO Voltage (Volts) | 2.75 | 2.75 | 2.5 | 2.25 | 2.25 |
| Area (Cell count) | 6562 | 6570 | 6568 | 6513 | 6514 |
| Total Power (in Milliwatt) | 21.30 | 21.00 | 17.60 | 14.40 | 13.90 |
| Datapath Delay (in Pico Second) | 1691 | 1542 | 5180 | 7986 | 8303 |

The synthesised filter's PnR (place and route) was performed using the Cadence Innovus tool. PnR in chip design involves optimising the physical layout of components and interconnections on a chip to meet performance, power, and area constraints. Power/rail analyses were performed at the post-floor planning and the post-route stages. Detailed signoff Static Timing Analysis (STA) and Gate Level Simulation (GLS) were also performed before fabrication.

To ensure that the fabricated design produces the expected outcomes and meets all fabrication requirements, the following steps were performed:

1. Static Timing Analysis (STA): Xilinx Design Constraint (XDC) and Synopsys Design Constraint (SDC) files are prepared to ensure the fabricated design meets all timing requirements. The clock signal is generated at a 50 MHz frequency with the desired clock uncertainty, rise and fall delay, and clock latency. The reset signal is set as the ideal network, and the remaining inputs and all outputs are constrained with the desired input and output delays.

2. Design Prototyping on AMD Xilinx FPGA Boards: FPGAs are an evolution of Programmable Logic Devices (PLDs), which are reconfigurable circuits. The distinguishing factors between variants of PLDs and FPGAs are typically their internal architecture, interfaces to external sources, and complexity. Two Xilinx Artix-7 FPGA boards are used to test the evolved FIR filter's functionality. The FIR filter core is implemented on the 'slave' FPGA board, whereas inputs and outputs are provided/collected by the 'master' FPGA board using a Serial Peripheral Interface (SPI). Coordinates of a distorted sinusoidal wave are transmitted through SPI as input from the 'master' to the 'slave'. Later, the same 'slave' architecture is implemented on ASIC using TSMC 65 nm technology.

Figure 9 shows SPI interfacing between the "master" and "slave" FPGAs. Figure 10 shows a schematic diagram of the internal architecture of the "slave" FPGA.

The 'slave' architecture consists of five input signals ('resetEX', 'sck', 'ss', 'mosi', and 'inEX') and two output signals ('miso' and 'outEX'), four of which are standard SPI signals ('sck', 'ss', 'mosi', and 'miso'). The 'sck' and 'ss' signals are the clock signal and slave select signals generated by the 'master,' respectively. 'mosi' carries eight coefficients of 8 bits each, and 'miso' transfers the filtered output bits generated by the FIR filter. 'inEX' is a 10-bit bus that provides inputs to the FIR filter, and 'outEX' is a 22-bit bus that carries the outputs generated by the filter. 'miso' and 'outEX' are used for the same purpose-to accumulate the output bits-but the only difference is the former does it serially, and the latter does it in parallel.

As mentioned earlier, the 'master' and the 'slave' are connected using SPI as shown in Figure 9. The coordinates of the distorted sinusoidal wave are pre-loaded in a single port ROM (IP) of the 'master' which are transported to the 'slave' through the 'inEX' bus. The distorted sinusoidal wave is generated using MATLAB.

The coefficients for the FIR filter are collected from the user through the 'sw0'-'sw7' signals and transmitted to the 'slave' through the 'mosi' signal serially. The 'master' is responsible for generating the signals 'sck' and 'ss' based on the required logic. It is also responsible for accumulating the output bits coming from the 'slave' through the 'miso' signal. Finally, the accumulated 'miso' bits are represented in integer form using eight 7-segment blocks available on the 'master' FPGA board.

3. Gate-Level Simulation (GLS): GLS is a post-synthesis simulation that ensures that the output of the design at a higher level of abstraction matches the output of the gate-level netlist. Only the source file gets replaced, whereas the test bench parameters remain the same. Library-specific Verilog/VHDL files are also essential to run the GLS. TSMC 65 nm technology libraries (.v files) were used to run the GLS.

*3. Other aspects:*

Multi Objective Optimization of Silicon

The invention uses "Multi-objective optimization" (MOO) to evolve circuits. In the specific example described above, MOO was used to balance between error (minimize) and correlation (maximise). However, various factors can also be used. These factors could include: minimize power consumption; minimize real estate (of silicon) usage; optimize speed of device; minimize latency by implementing functions directly in hardware, bypassing the need for software execution; maximize throughput by efficiently utilizing hardware resources and optimizing data paths; minimize cost of components, for example, hard core CPUs on FPGAs.

This will enable the invention to be used to create suites or even libraries of different hardware designs/options for the same problem.

Incorporating Useful Components

Some human knowledge was captured prior to evolving the solution. Specifically, the general structure of the FIR filter in terms of delay element (D flip-flop), multiplier and adder were added to the grammar model as useful composite elements of the model. In other examples, the grammar model can include: useful IP blocks; details of on-chip functionality such as RAM, processors, etc., as these are often present on FPGAs; known useful hardware and data structures for the particular circuit being generated. The ability to include likely components as part of the grammar allows the optimisation to better reach likely optimal results.

Full integration into the EDA flow

Figure 5 shows the standard EDA flow. The invention could be seamlessly integrated with the Program Design/Functional Simulation/Synthesis/Gate Level Functional Simulation flow, fully automating the process.

Automatic hardware acceleration

The system has been designed to generate digital circuits for ASICs. However, the system can easily be adopted to perform hardware acceleration in FPGAs by integrating with software IDEs (Integrated Development Environments), by enabling programmers to dispatch software modules for hardware acceleration even though they have no expertise with silicon design.

Natural Language Design

Due to the structured nature of the system, some examples of the present disclosure could integrate Natural Language Processing (NLP) and Large Language Models (LLMs) to create an interactive system where end-users can specify requirements using natural language in an iterative way, where the system will request more information as required.

Recap

A key aspect of this invention is the ability to create synthesizable circuits. There has been a significant amount of prior work that simulatable circuits, that is, circuits which can be tested in a simulator, but a successful simulation does not guarantee that the circuit can be synthesized in silicon. This is because simulation can include non-synthesizable constructs that behave correctly in a software environment but cannot be mapped to actual hardware components, and timing issues or resource constraints might not be fully accounted for in the simulation process. Moreover, missing conditions or incomplete logic definitions in the HDL code can lead to the unintended generation of latches during the synthesis process, which in turn creates timing problems, debugging challenges, and non-portable designs.

Synthesizable circuits can be created by default because the grammar utilized in the Grammatical Evolution (GE) engine is explicitly designed to generate individuals (circuits) using synthesizable HDL constructs only. This approach ensures that the search process is inherently limited to hardware-compatible constructs, avoiding issues related to missing conditions or incomplete logic definitions. As a result, every generated circuit is optimized and ready for direct implementation in silicon.

Logic synthesis is the process of converting high-level Hardware Descriptions Language (HDL) code (typically in Verilog or VHDL) into a gate-level representation. This step translates abstract logic and behaviour into a network of logic gates (AND, OR, NOT, etc.) and digital components that can be physically implemented on a chip. The goal is to optimize the design for performance, power, and area while ensuring it meets functional requirements. Logic synthesis bridges the gap between high-level design and physical implementation in digital circuit design.

Certain HDL constructs are non-synthesizable-useful for simulation but not translatable into hardware. This complexity underscores the need for skilled engineers in IC design. In the ADDC project, Grammatical Evolution (GE), a machine learning technique, is used to generate synthesizable HDL code. The best circuit is selected based on its fitness score. To validate that GE-generated designs are hardware-implementable, one of the evolved circuits is prototyped on the AMD Xilinx Nexys-A7 FPGA board, then fabricated as a chip (ASIC) using 65 nm technology.

The specific examples described above in relation to the figures are only examples of how the present concepts could be implemented and the present disclosure is not limited to these narrow examples but variations are possible within the scope of the claims.

## Claims

1. A computer-implemented method for circuit generation, comprising:

   receiving parameters specifying functionality of a circuit to be designed;
   optimising one or more circuit designs based on a suitability score that depends at least in part on the suitability of the one or more circuit designs for achieving the specified functionality; wherein
   the optimising comprises using a grammar based optimisation engine configured to perform a grammar based optimisation in which the one or more circuit designs and any optimisations accord to a selected grammar that describes the structure and/or behaviour of electronic circuits and configured to result in synthesisable circuit components; and
   the optimising outputs an optimised circuit design.

2. The computer-implemented method of claim 1, wherein the selected grammar comprises a plurality of electronic circuit elements that can be combined with one another to form a circuit design, each electronic circuit element comprising either a single circuit component or a combination of circuit components, and wherein a subset of the plurality of electronic circuit elements comprises predefined combinations of circuit components; optionally wherein each of the one or more circuit designs comprises a combination of electronic circuit elements of the plurality of electronic circuit elements, and wherein the optimising includes generating variants of the one or more circuit designs by: combining subsets of electronic circuit elements from two or more previously generated circuit designs, or replacing one or more elements of a previously generated circuit design with one or more different electronic circuit elements, to form a new circuit design.

3. The computer-implemented method of claim 2, wherein the selected grammar comprises one or more rules prohibiting the combination of two or more particular electronic circuit elements in a circuit design to avoid generating non-functioning circuit designs.

4. The computer-implemented method of any of the preceding claims, wherein the one or more circuit designs comprise components of a hardware description language expressed in a formal grammar.

5. The computer-implemented method of any of the preceding claims, wherein the optimising comprises simulating iteratively a behaviour of the one or more circuit designs, and wherein, during one or more earlier cycles of simulating iteratively, a first simulation model is used, and, during one or more later cycles of simulating iteratively, a second simulation model is used that different from the first simulation model; optionally wherein the first simulation model is configured to provide less information about a simulated circuit but to execute more quickly compared to the second simulation model and the second simulation model is configured to provide more information, or more accurate information, about a simulated circuit but to execute less quickly compared to the first simulation model; or optionally wherein the first simulation model is configured to perform a functional simulation that simulates a behaviour of a simulated circuit, and wherein the second simulation model is configured to perform a gate-level simulation that simulates a behaviour of the simulated circuit after the circuit has been converted to a corresponding circuit of logic gates.

6. The computer-implemented method of any of the preceding claims, wherein the optimising comprises simulating iteratively a behaviour of the one or more circuit designs, and wherein, during one or more cycles of simulating iteratively, the one or more circuits are optimised using less than all of the received parameters.

7. The computer-implemented method of any of the preceding claims, wherein the optimising is performed using a grammar-based machine learning tool or wherein the method further comprises manufacturing a circuit according to the optimised one or more circuit designs.

8. The computer-implemented method of any of the preceding claims, wherein receiving parameters specifying functionality of a circuit to be designed comprises receiving, from a user, testbench parameters specifying functionality of a circuit to be designed, the testbench parameters comprising sets of one or more input parameters and corresponding sets of one or more output parameters, optionally wherein at least one of the one or more output parameters corresponds to a functionality of the circuit to be designed.

9. The computer-implemented method of any of the preceding claims, wherein receiving parameters specifying functionality of a circuit to be designed comprises receiving one or more performance parameters specifying a performance of the circuit to be designed.

10. The computer-implemented method of claim 9, wherein the one or more performance parameters specify one or more of: a threshold power consumption, a threshold circuit area, a threshold processing speed, a threshold latency, a threshold throughput, or a threshold component cost.

11. The computer-implemented method of any of the preceding claims, wherein the optimising comprises:
simulating a behaviour of each one or more circuit designs and determining a suitability score for each circuit design using one or more fitness functions that quantify the extent to which sets of output parameters in the received parameters are achieved when each of the one or more circuits are provided with corresponding inputs of the received parameters, optionally wherein the optimising comprises:

> subsequently, determining, based on the suitability scores, that a condition is not met by any of the one or more circuit designs;
> generating iteratively, sets of variants of circuit designs, and simulating iteratively a behaviour of each circuit design in each set of variants to determine a suitability score for each circuit design using the one or more fitness functions;
> wherein each set of variants is generated by modifying a corresponding previous set of circuit designs, such that previous circuit designs having higher suitability scores are more likely to be selected to generate a subsequent set of variants; and
> wherein the generating iteratively and simulating iteratively are repeated until a final set of variants is generated and determined, based on corresponding suitability scores, to include one or more circuit designs that meet the condition.

12. A computer system comprising:

> one or more processors; and
> a memory storing executable instructions that, once executed by the one or more processors, cause the one or more processors to perform steps comprising:

>> receiving parameters specifying functionality of a circuit to be designed;
>> optimising one or more circuit designs based on a suitability score that depends at least in part on the suitability of the one or more circuit designs for achieving the specified functionality; wherein

>> the optimising comprises using a grammar based optimisation engine configured to perform a grammar based optimisation in which the one or more circuit designs and any optimisations accord to a selected grammar that describes the structure and/or behaviour of electronic circuits and configured to result in synthesisable circuit components; and
>> the optimising outputs an optimised circuit design.

13. A computer program product which, when executed by one or more processors, causes the one or more processors to perform the method of claim 1.

14. A non-transitory computer readable medium storing instructions which, when executed by a processor, cause the processor to perform steps comprising:

receiving parameters specifying functionality of a circuit to be designed;

optimising one or more circuit designs based on a suitability score that depends at least in part on the suitability of the one or more circuit designs for achieving the specified functionality; wherein

the optimising comprises using a grammar based optimisation engine configured to perform a grammar based optimisation in which the one or more circuit designs and any optimisations accord to a selected grammar that describes the structure and/or behaviour of electronic circuits and configured to result in synthesisable circuit components; and

the optimising outputs an optimised circuit design.

15. A computer-implemented method of designing a circuit, comprising:

receiving, from a user, testbench parameters specifying intended functionality of a circuit to be designed, the testbench parameters comprising sets of one or more input parameters and corresponding sets of one or more output parameters;

generating, using a subset of a grammar of circuit components, the subset of the grammar corresponding to manufacturable circuit components, an initial set of circuit designs in a hardware description language;

simulating a behaviour of each circuit design of the initial set of circuit designs and determining a suitability score for each circuit design using one or more fitness functions that quantify the extent to which the sets of output parameters are achieved when each initial circuit is provided with inputs corresponding to the respective sets of input parameters;

determining, based on the suitability scores, that a condition is not met by any of the circuit designs in the initial set of circuit designs;

generating iteratively, sets of variants of circuit designs, and simulating iteratively a behaviour of each circuit design in each set of variants to determine a suitability score for each circuit design using the one or more fitness functions;

wherein each set of variants is generated probabilistically by modifying a corresponding previous set of circuit design, such that previous circuit designs having higher suitability scores are more likely to be selected to generate a subsequent set of variants;

wherein the generating iteratively and simulating iteratively are repeated until a final set of variants is generated and determined, based on corresponding suitability scores, to include one or more circuit designs that meet the condition; and

outputting the one or more circuit designs to a user.

1

## Computer
## 2

Processor(s)
4

Memory
6

Instructions
8

Simulation
Models
16

Circuit Designs
20

Grammar
Model
18

Testbench
Parameters
22

Fitness
Functions
24

Simulation
Results
26

Weightings
28

Input
Peripherals
12

Output
Peripherals
14

Network
Interface
10

Remote
Device
11

## Fig. 1

100

Receive testbench parameters — 102

Generate initial circuit designs and corresponding HDL models — 104

Simulate behaviour of initial circuit designs — 106

Determine suitability scores using fitness functions — 108

Determine whether testbench parameters met by circuit designs — 110

Generate set of variants of circuit designs based on previous set — 112

Select simulation model

Iterate until testbench parameters met

A

114

B

120

**Fig. 2A**

100

A       B

Simulate behaviour of circuit designs
in the current set     116

Determine suitability scores for
circuit designs in the set     118

Output final set of circuit designs     122

Create prototype circuit according to
final set of circuit designs     124

Manufacture circuit according to
final set of circuit designs     126

Perform further testing     128

**Fig. 2B**

22

Input Signal
1-A

Input Signal
1-B

Input Signal
1-C

A
B
C

Circuit

D
E

21

Output
Signal 1-D

Output
Signal 1-E

32

30

**Fig. 3A**

22

Input Signal
2-A

Input Signal
2-B

Input Signal
2-C

A
B
C

Circuit

D
E

21

Output 2-D

Output
Signal 2-E

36

34

**Fig. 3B**

200

Receive parameters specifying functionality of a circuit to be designed — 202

Optimise one or more circuit designs based on a suitability score that depends at least in part on the suitability of the one or more circuit designs for achieving the specified functionality — 204

Output an optimised circuit design — 206

**Fig. 4**

Fig. 5

Fig. 6

**Fig. 7A**

Fig. 7B

Fig. 8

**Fig. 9**

Fig. 10

Europäisches
Patentamt

European
Patent Office

Office européen
des brevets

## EUROPEAN SEARCH REPORT

**Application Number**

EP 24 21 3734

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | RYAN CONOR ET AL: "Behavioural Modelling of Digital Circuits in System Verilog using Grammatical Evolution :", PROCEEDINGS OF THE 12TH INTERNATIONAL JOINT CONFERENCE ON COMPUTATIONAL INTELLIGENCE (IJCCI'20), 2 November 2020 (2020-11-02), pages 28-39, XP093268029, DOI: 10.5220/0010066600280039 ISBN: 978-989-758-475-6 Retrieved from the Internet: URL:https://www.scitepress.org/Papers/2020/100666/100666.pdf> | 1-15 | INV. G06F30/327 G06F30/3323 G06F30/337 G06N3/126 |
| Y | * abstract; figures 1,2 * * page 29, left-hand column, paragraph 2-3 * * page 36, left-hand column, paragraph 3 * * section 2.4 paragraphs 1-2 * * page 28, right-hand column, paragraph 1 * * page 30, left-hand column, paragraph 1 * * section 2.3 paragraph 1; table 3 * * section 3.1 paragraph 1 * * table 1 * * section 3 paragraph 1 * * page 31, left-hand column, paragraph 1 * * the whole document * | 5 | |

| | |
|---|---|
| | TECHNICAL FIELDS SEARCHED (IPC) |
| | G06F G06N |

-----

-/--

The present search report has been drawn up for all claims

| Place of search | Date of completion of the search | Examiner |
|---|---|---|
| Munich | 8 April 2025 | Dapp, Wolfgang |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

EP 24 21 3734

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | Shi L. ET AL: "A Survey of Fitness Approximation Methods Applied in Evolutionary Algorithms" In: "Computational Intelligence in Expensive Optimization Problems", 1 January 2010 (2010-01-01), Springer Berlin Heidelberg, XP093268027, ISSN: 1867-4534 ISBN: 978-3-642-10700-9 pages 3-28, DOI: 10.1007/978-3-642-10701-6_1, Retrieved from the Internet: URL:https://link.springer.com/chapter/10.1 007/978-3-642-10701-6_1> * abstract * * the whole document * ----- | 5 | |
| A | MCELLIN JACK ET AL: "AVERT: An Automatic Verilog Testbench Generation Tool for Grammatical Evolution", 2022 33RD IRISH SIGNALS AND SYSTEMS CONFERENCE (ISSC), IEEE, 9 June 2022 (2022-06-09), pages 1-8, XP034151738, DOI: 10.1109/ISSC55427.2022.9826162 [retrieved on 2022-07-19] * abstract * * the whole document * ----- -/-- | 1-15 | TECHNICAL FIELDS SEARCHED (IPC) |

The present search report has been drawn up for all claims

| Place of search | Date of completion of the search | Examiner |
|---|---|---|
| Munich | 8 April 2025 | Dapp, Wolfgang |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EUROPEAN SEARCH REPORT**

Europäisches Patentamt
European Patent Office
Office européen des brevets

Application Number

EP 24 21 3734

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Ryan Conor ET AL: "ADDC: Automatic Design of Digital Circuit" In: "Genetic Algorithms", 4 June 2022 (2022-06-04), IntechOpen, XP093268034, ISBN: 978-1-80355-178-4 pages 1-25, Retrieved from the Internet: URL:https://www.intechopen.com/chapters/82121> * abstract * * the whole document * ----- | 1-15 | |

TECHNICAL FIELDS SEARCHED (IPC)

The present search report has been drawn up for all claims

| Place of search | Date of completion of the search | Examiner |
|---|---|---|
| Munich | 8 April 2025 | Dapp, Wolfgang |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 3 of 3